Europäisches Patentamt

European Patent Office

Office européen des brevets

(19)

(11) **EP 1 027 707 B1**

(12) **EUROPÄISCHE PATENTSCHRIFT**

(45) Veröffentlichungstag und Bekanntmachung des Hinweises auf die Patenterteilung:
**13.03.2002 Patentblatt 2002/11**

(21) Anmeldenummer: **98956859.7**

(22) Anmeldetag: **21.10.1998**

(51) Int Cl.[7]: **G11C 29/00**

(86) Internationale Anmeldenummer:
**PCT/EP98/06673**

(87) Internationale Veröffentlichungsnummer:
**WO 99/23665 (14.05.1999 Gazette 1999/19)**

(54) **VERFAHREN ZUR PRÜFUNG DER BUSANSCHLÜSSE VON BESCHREIB- UND LESBAREN INTEGRIERTEN, ELEKTRONISCHEN SCHALTKREISEN, INSBESONDERE VON SPEICHERBAUSTEINEN**

METHOD FOR TESTING THE BUS TERMINALS OF WRITABLE-READABLE INTEGRATED ELECTRONIC INTEGRATED CIRCUITS, ESPECIALLY OF MEMORY CHIPS

PROCEDE DE VERIFICATION DES CONNEXIONS BUS DE CIRCUITS DE COMMUTATION ELECTRONIQUES INTEGRES LISIBLES ET ENREGISTRABLES, NOTAMMENT DE MODULES MEMOIRES

(84) Benannte Vertragsstaaten:
**DE FR GB IE IT**

(30) Priorität: **03.11.1997 EP 97119180**

(43) Veröffentlichungstag der Anmeldung:
**16.08.2000 Patentblatt 2000/33**

(73) Patentinhaber: **Infineon Technologies AG**
**81669 München (DE)**

(72) Erfinder:
- **DIECKMANN, Andreas**
**D-90602 Pyrbaum (DE)**
- **DONDERER, Markus**
**D-92224 Amberg (DE)**

(74) Vertreter: **Müller . Hoffmann & Partner**
**Patentanwälte**
**Innere Wiener Strasse 17**
**81667 München (DE)**

(56) Entgegenhaltungen:
- **NADEAU-DOSTIE B. ET AL.: "Serial interfacing for embedded-memory testing" IEEE DESIGN & TEST OF COMPUTERS., April 1990, Seiten 52-63, XP000159643 LOS ALAMITOS US**
- **MAXFIELD C.: "My memory is not what it used to be: testing RAMs and ROMs" EDN ELECTRICAL DESIGN NEWS., Bd. 41, Nr. 3, 1. Februar 1996, Seiten 153-160, XP000557297 NEWTON, MASSACHUSETTS US**
- **TREUER R. ET AL.: "Built-in self-diagnosis for repairable embedded RAMs" IEEE DESIGN & TEST OF COMPUTERS., Bd. 10, Nr. 2, Juni 1993, Seiten 24-33, XP000369670 LOS ALAMITOS US**

**Beschreibung**

Zum Aufbau von stark miniaturisierten Anordnungen aus elektronischen und elektrischen Bauelementen können fein strukturierte Leiterplatten, Hybridanordnungen und zunehmend auch Multichipmodule eingesetzt werden. Bei einem Multichipmodul handelt es sich um eine Anordnung, bei der mehrere gehäuselose Chipbausteine mit Hilfe eines Trägers miteinander kontaktiert sind. Häufig werden dabei Chipbausteine eingesetzt, welche hochintegrierte beschreibbare, elektronische Schaltkreise darstellen. Derartige Chipbausteine sind zumindest über einen Adreß- und einen Datenbus mit weiteren elektronischen Schaltkreisen verbunden, z.B. mit Prozessoren bzw. mit Chipbausteinen gleichen Typs. Der letztgenannte Fall tritt insbesondere dann auf, wenn es sich bei den Chipbausteinen um Speicherbausteine handelt, z.B. sogenannte RAM's. Mit Hilfe des Adreßbusses können speichernde Elemente bzw. Speicherzellen im Inneren eines Chipbausteins so angesprochen werden, daß über den Datenbus eine in der Regel binärcodierte Information, d.h. ein sogenanntes Datum, in eine Zelle eingeschrieben bzw. daraus ausgelesen werden kann. Als Träger für den mindestens einen, u.U. gehäuselosen Chipbaustein kann z.B. ein Siliciumsubstrat oder eine Leiterplatte dienen. Ein solcher Aufbau kann in einem Gehäuse untergebracht sein, welches in der Regel eine Fülle von zum Datenaustausch dienenden äußeren, elektrischen Anschlußkontakten aufweist.

Es hat sich in der Praxis gezeigt, daß beim Aufbau von fein strukturierten Anordnungen Fehler insbesondere bei der elektrischen Kontaktierung eines z.B. gehäuselosen Chipbausteines mit einem Träger bzw. den Leitungsführungen auf dem Träger auftreten. Fehler treten somit insbesondere bei den dabei nötigen Löt- bzw. Bondverbindungen auf. Andererseits wird in der Regel für die Durchführung eines Verbindungstests vorausgesetzt, daß der Chipbaustein selbst und dessen Trägersubstrat frei von Fehlern sind, da diese meist separat vorgeprüft wurden. Die bei einer kontaktierenden Verbindung von einem Chipbaustein und einem Träger möglichen Fehler können unterschiedlichen Typs sein. Ein erster Fehlertyp wird als "stuck-at fault" bezeichnet und betrifft eine kurzschlußartige Verbindung von einer Adreß- bzw. Datenbusleitung. Dabei betreffen ein sogenannter "stuck-at 0" bzw. "stuck-at 1" Fehler eine Verbindung von einer Adreß- bzw. Datenbusleitung mit Masse bzw. einem Spannungspotential. Ein zweiter, als "bridging fault" bezeichneter Fehlertyp betrifft Verbindungen zwischen mehr als zwei Adreß- bzw. Datenbusleitungen. Ein dritter Fehlertyp wird schließlich als "open fault" bezeichnet. Dabei weist eine Adreß- bzw. Datenbusleitung eine Unterbrechung auf. Abhängig von der Art der Leitungsunterbrechung liegt ein sogenannter "open 0" bzw. ein "open 1" Fehler vor, wenn das sich einstellende Potential auf der Leitung mit dem Pegel für logisch Null bzw. dem Pegel für logisch Eins vergleichbar ist.

Derartige Fehler bewirken, daß der Datenfluß zwischen einem betroffenen Chipbaustein und einer diesen Chipbaustein enthaltenden elektronischen Schaltung gestört ist. Besonders problematisch sind dabei Fehler bei Leitungen bzw. Kontaktverbindungen auf dem Träger, welche Bestandteil eines Datenoder Adreßbusses sind, d.h. den Büsanschlüssen eines beschreib- und lesbaren integrierten, elektronischen Schaltkreises. Es ist somit notwendig, bei fein strukturierten Aufbauten, wie z.B. einem Multichipmodul, die Verbindungen zwischen Träger und elektronischem Schaltkreis insbesondere auf das Vorliegen von Unterbrechungen zu überprüfen.

Es ist bekannt, zum Prüfen der Anschlüsse auf den Oberflächen von Leiterplatten z.B. sogenannte »in circuit« Tests einzusetzen. Dabei werden ausgewählte Punkte der Leiterplatte bzw. Anschlüsse von darauf befindlichen elektronischen Bauelementen mit speziellen Nadeln oder Prüfspitzen äußerlich kontaktiert. Hierdurch können während des Betriebes der auf einer Leiterplatte befindlichen elektrischen Schaltung auftretende Signale abgenommen und in angeschlossenen, speziellen Prüfvorrichtungen ausgewertet werden. Diese Technik ist aber wegen der geringen Abmessungen nicht zum Prüfen z.B. von Multichipmodulen bzw. fein strukturierten Leiterplatten anwendbar. Deswegen müssen bei derartigen Anordnungen häufig elektronische Testverfahren eingesetzt werden. Dabei werden standardmäßig vorhandene und entsprechend leicht zugängliche Eingangsanschlüsse eines elektronischen Schaltkreises mit ausgewählten Bitmustern belegt. Die in Reaktion darauf an weiteren, ebenfalls standardmäßig vorhandenen und leicht zugänglichen Ausgangsanschlüssen auftretenden Bitmuster können zur Detektion insbesondere von Kurzschlüssen und Unterbrechungen ausgewertet werden. Die Ankopplung einer Prüfvorrichtung ist beispielsweise dann einfach, wenn der Adreß- und Datenbus eines elektronischen Schaltkreises z.B. über Steckverbinder von außen zugänglich ist, bzw. wenn z.B. ein gehäuseloser Speicherbaustein auf einem Träger angebracht ist und auf der Trägeroberfläche leicht zugängliche Kontaktpunkte für die Leitungen von Adreß- und Datenbus vorhanden sind.

Bei elektronischen Testverfahren tritt grundsätzlich das Problem auf, daß durch ein Einschreiben und ein anschließendes Rücklesen eines Musters von ausgewählten Prüfbits zwar ein Fehler auf einer Leitung des Datenbusses des zu prüfenden elektronischen Schaltkreisen detektierbar ist. Es ist auf diese Weise aber nicht möglich, einen Fehler auf einer Leitung des dazugehörigen Adreßbusses zu erfassen. In einem solchen Falle wird das Prüfbitmuster zwar in eine Speicherzelle des elektronischen Schaltkreises eingeschrieben, deren Adresse auf Grund des vorliegenden Fehlers nicht mit der jeweils vorgegebenen Adreßangabe übereinstimmt. Beim Rücklesen wird das Prüfbitmuster aber wieder aus der gleichen, bezüglich der vorliegenden Adreßangabe zwar "falschen" Speicherzelle ausgelesen, ohne daß ein Adreßbusfehler bei diesem Vorgang in Erscheinung tritt. Aus diesem Grund müssen spezielle Prüfbitmuster eingesetzt werden, um auch die Detektion eines insbesondere auf einer Unterbrechung beruhenden Fehlers auf dem Adreßbus eines beschreib- und lesbaren integrierten, elektronischen Schaltkreisen zu detektieren.

Aus der Veröffentlichung von C. Maxfield mit dem Titel "Testing RAMs and ROMs"; EDN; February 1, 1996, Seiten 153 bis 160 ist ein elektronisches Verfahren zur Prüfung der Verbindungen z.B. von Speicherbausteinen bekannt. Dabei werden die Leitungen der Busse eines Speicherbausteines mit einer Folge von Prüfbitmustern beschrieben, welche als "walking-ones sequence" oder auch March-0/1 Algorithmus bezeichnet werden kann. Dabei wird jede Leitung der in der Regel viele Bits breiten externen Adreß- und Datenbusse eines Speicherbausteines in auf- oder absteigender Reihenfolge einmal selektiv mit dem logischen 1 Pegel stimuliert, während die übrigen Leitungen des Adreß- bzw. Datenbusses mit dem logischen 0 Pegel getrieben werden. Hiermit ergeben sich z.B. bei einem vier Bit breiten und die Datenbits D3,D2,D1,D0 aufweisenden Datenbus als Prüfbitmuster die Kombinationen 0,0,0,0 und 0,0,0,1 und 0,0,1,0 und 0,1,0,0 und 1,0,0,0.

Dieses Verfahren weist den Nachteil auf, daß eine relativ hohe Anzahl an schreibenden und lesenden Zugriffen notwendig ist, um Fehler zu detektieren. So sind z.B. bei einem 8-Bit breiten Adreßbus und einem 1-Bit-breiten Datenbus normalerweise 64 Schreib- und 64 Lesezugriffe erforderlich. Lediglich bei den Schreibzugriffen ist gegebenenfalls eine Reduzierung auf 22 möglich. So sind aber insgesamt noch immer 86 Speicherzugriffe nötig. Demgegenüber werden in diesem Beispiel bei Anwendung des erfindungsgemäßen Verfahrens nur 34 Speicherzugriffe benötigt, d.h. 17 Schreib- und 17 Lesezugriffe, um mögliche Unterbrechungen beim Adress- oder Datenbus zu detektieren und zu lokalisieren.

Ein weiteres elektronisches Testverfahren für die Anschlußverbindungen z.B. von Speicherbausteinen wird beschrieben in der Veröffentlichung von F.d. Jong und A.J.d.L. van Wijngaarden mit dem Titel "Memory interconnect test at board level" veröffentlicht in 23rd IEEE International Test Conference; 1992; Seiten 328-337. Auch dieses hat den Nachteil, daß eine relativ hohe Anzahl an schreibenden und lesenden Zugriffen auf die Zellen eines zu testenden Speichers notwendig ist, um alle möglichen, bei unterbrochenen Verbindungen auftretenden Fehlerbilder erkennen und die dazugehörigen Leitungen detektieren zu können. So sind bei diesem elektronischen Testverfahren für die Überprüfung jeder Leitung des Adreßbusses, d.h. jeder Adreßleitung, zwei Schreibzugriffe und ein Lesezugriff auf den Speicherbaustein, und zusätzlich für die Überprüfung jeder Leitung des Datenbusses, d.h. jeder Datenleitung, ein Schreib- und ein Lesezugriff auf den Speicherbaustein erforderlich. Um alle möglichen Fehlerbilder für unterbrochene Verbindungen abzudecken, erfordert somit auch dieses Verfahren eine erhebliche Anzahl an Speicherzugriffen.

In dem Fachbuch von M. Gerner, B. Müller, G. Sandweg mit dem Titel "Selbsttest digitaler Schaltungen", R. Oldenbourg Verlag München Wien 1990 wird auf den dortigen Seiten 221 bis 224 ein sogenannter "RAM-Selbsttest mit deterministischen Testmustern" beschrieben. Das Verfahren beruht darauf, daß die jeweilige Adresse einer Speicherzelle auch als Datenwort in die Speicherzelle eingeschrieben wird. Dabei wird in einer Initialisierungsphase zunächst wortweise in jedes Speicherwort die dazugehörige Adresse eingeschrieben. Es schließen sich ein Lesezyklus mit einem Soll-Istwertvergleich und bis zu vier weitere Durchläufe an, welche als Phasen 1 bis 4 bezeichnet werden. Dabei werden invertierte und nicht invertierte, aufsteigende und fallende Adreßfolgen als Datenwerte in jede einzelne Zelle des Speichers eingeschrieben, rückgelesen und verglichen. Das Verfahren ermöglicht es zwar, eine große Anzahl von im Inneren von Speichern möglichen Fehlertypen zu erkennen, so stuck-at Fehler, einseitige Kopplungen und Kurzschlüsse, erfordert aber andererseits eine sehr hohe Anzahl an schreibenden und lesenden Speicherzugriffen in mehreren, aufeinanderfolgenden Prüfdurchläufen.

Aus der Druckschrift TREUER ET AL.: 'Built-in self-diagnosis for repairable embedded RAMs' IEEE DESIGN & TEST OF COMPUTERS., Bd. 10, Nr. 2, Juni 1993, Seiten 24-33, XP000369670, LOS ALAMITOS, US, ist ein Verfahren zur Speicherprüfung bekannt, das als Datenprüfbitmuster das sogenannte "marching data background"-Muster verwendet, das darin besteht, dass in einem ersten Schritt alle Bits des Datenprüfbitmusters eine übereinstimmende binäre Wertigkeit (0000 oder 1111) aufweisen, und dass weiterhin pro folgendem Schritt, beginnend beim nieder- oder höchstwertigsten Bit im Datenprüfbitmuster dem jeweils benachbarten Bit die im Vergleich zum vorangegangenen Schritt (z. B. 0000 nach dem ersten Schritt oder 0001 nach dem zweiten Schritt) jeweils komplementäre binäre Wertigkeit (0001 nach dem zweiten Schritt oder 0011 nach dem dritten Schritt) zugeordnet wird, bis schließlich in einem letzten Schritt alle Bits des Datenprüfbitmusters eine zum jeweiligen ersten Schritt komplementäre binäre Wertigkeit (1111 oder 0000) aufweisen.

Der Erfindung liegt die Aufgabe zu Grunde, ein Verfahren zur Prüfung der Busanschlüsse von beschreib- und lesbaren integrierten, elektronischen Schaltkrelsen anzugeben, d. h. den äußeren Verbindungen z. B. von SRAM-, DRAM- oder Flash Memory Bausteinen, welche z.B. in gehäuseloser Form auf einer Leiterplatte oder einem Multichipmodul eingesetzt sind.

Die Aufgabe wird gelöst mit dem im Anspruch 1 angegebenen Verfahren.

Das erfindungsgemäße Verfahren dient zur Überprüfung der Kontaktanschlüsse eines schreib- und lesbaren integrierten, elektronischen Schaltkreises, insbesondere eines Speicherbausteins, an einem Adreß- und einem Datenbus.

Dabei wird in mindestens einer ersten Folge von Schreibschritten der Adreßbus schrittweise mit ausgewählten Adreßbitprüfmustern belegt und es werden ausgewählte Datenbitprüfmuster auf dem Datenbus in den Schaltkreis geschrieben. Daraufhin wird in mindestens einer ersten Folge von Leseschritten der Adreßbus wiederum schrittweise mit den ausgewählten Adreßbitprüfmustern belegt und die dazugebörigen Datenbitmuster auf dem Datenbus werden aus dem Schaltkreis gelesen. In mindestens einer ersten Folge von Prüfschritten werden nun die gelesenen Datenbitmuster mit den ausgewählten Datenprüfbitmustern verglichen und bei Abweichungen, insbesondere durch Mustervergleich mit Adreß- und Datenbitfehlermustern, die fehlerhafte Leitung auf dem Adreßbus bzw. Datenbus lokalisiert wird.

Gemäß der Erfindung sind die Adreß- und Datenbitprüfmuster so ausgewählt, dass in einem ersten Schritt der ersten Folge von Schreib- bzw. Leseschritten die Bits des Adreßbitprüfmusters eine erste, übereinstimmende binäre Wertigkeit, und im ersten Schritt der ersten Folge von Schreibschritten die Bits des Datenbitprüfmusters eine zweite, übereinstimmende binäre Wertigkeit aufweisen. Pro folgendem Schritt der jeweiligen Folge von Schreib- bzw. Leseschritten wird, beginnend beim nieder oder höchstwertigsten Bit im Adreß- bzw. Datenbitprüfmuster, dem jeweils benachbarten Bit die im Vergleich zum vorangegangenen Schritt jeweils komplementäre binäre Wertigkeit zugeordnet, bis in einem letzten Schritt der Folge von Schreib bzw. Leseschritten alle Bits des Adreß- bzw. Datenbitprüfmusters eine zum jeweiligen ersten Schritt komplementäre binäre Wertigkeit aufweisen.

Das erfindungsgemäße Verfahren bietet den Vorteil, daß nicht nur die Detektion des Auftretens eines Fehlers möglich ist, sondern mit einer minimalen Anzahl an einzuschreibenden und rückzulesenden Datenbitprüfmustern auch die genaue Lokalisierung des Fehlerortes. Es ist somit eine Detektion der jeweils fehlerhaften Verbindung zwischen einem Anschluß des Adreßbzw. Datenbusses eines elektronischen Schaltkreises und insbesondere einem tragenden Substrat möglich, z.B. einer Leiterplatte. Auch wenn der Zweck eines derartigen Verfahrens in der Lokalisierung des jeweils fehlerhaften Bits auf einer Leitung des Adreß- oder Datenbusses liegt, und somit die Fehlerart von untergeordneter Bedeutung ist, so ist das erfindungsgemäße Verfahren besonders geeignet zur Lokalisierung des Fehlerortes von sogenannten "open 0" und "open 1" Fehlertypen, und bei der Überprüfung von Einzelbausteinen auch von sogenannten "stuck-at 0" und "stuck-at 1" Fehlern.

Weitere vorteilhafte Ausführungen des erfindungsgemäßen Verfahrens sind in den Unteransprüchen angegeben.

Die Erfindung wird an Hand von in den nachfolgend kurz angeführten Figuren dargestellten Ausführungsbeispielen näher erläutert. Dabei zeigt

FIG 1 :    am Beispiel eines jeweils 4 Bit breiten Adreß- und Datenbusses eine Folge von Prüfbitmustern gemäß der Erfindung für den Fall, daß die Leitungen von Adreß- und Datenbus fehlerfrei sind,

FIG 2 bis 5 :    am Beispiel von jeweils 4 Bit breiten Adreßbussen weitere, gemäß der Erfindung mögliche Folgen von Adreßbitprüfmustern,

FIG 6 bis 9 :    am Beispiel von jeweils 4 Bit breiten Datenbussen weitere, gemäß der Erfindung mögliche Folgen von Datenbitprüfmustern,

FIG 10 :    am Beispiel eines jeweils 4 Bit breiten Adreß- und Datenbusses eine Folge von Prüfbitmustern gemäß der Erfindung für den Fall, daß die Adreßleitung A0 des Adreßbusses einen "open 0" Fehler aufweist,

FIG 11 :    am Beispiel eines jeweils 4 Bit breiten Adreß- und Datenbusses eine Folge von Prüfbitmustern gemäß der Erfindung für den Fall, daß die Datenleitung D0 des Datenbusses einen "open 0" Fehler aufweist,

FIG 12 :    am Beispiel eines jeweils 4 Bit breiten Adreß- und Datenbusses eine Folge von Prüfbitmustern gemäß der Erfindung für den Fall, daß die Adreßleitung A0 des Adreßbusses einen "open 1" Fehler aufweist,

FIG 13 :    am Beispiel eines jeweils 4 Bit breiten Adreß- und Datenbusses eine Folge von Prüfbitmustern gemäß der Erfindung für den Fall, daß die Datenleitung D0 des Datenbusses einen "open 1" Fehler aufweist,

FIG 14 :    eine Gegenüberstellung der in den Beispielen der Figuren 10, 11, 12, 13 auftretenden Fehlerbilder auf den Datenleitungen der jeweiligen Datenbusse,

FIG 15 :    am Beispiel eines 6 Bit breiten Adreßbusses und eines 4 Bit breiten Datenbusses eine Folge von Prüfbitmustern gemäß der Erfindung für den Fall, daß die Leitungen von Adreß- und Datenbus fehlerfrei sind,

FIG 16 :    am Beispiel eines 6 Bit breiten Datenbusses und eines 4 Bit breiten Adreßbusses den Anfang einer Folge von Prüfbitmustern gemäß der Erfindung für den Fall, daß die Leitungen von Adreß- und Da-

EP 1 027 707 B1

tenbus fehlerfrei sind,

FIG 17 : am Beispiel eines 9 Bit breiten Adreßbusses und eines 4 Bit breiten Datenbusses eine Folge von Prüfbitmustern gemäß der Erfindung für den Fall, daß die Leitungen von Adreß- und Datenbus fehlerfrei sind,

FIG 18 : am Beispiel eines 6 Bit breiten Adreßbusses und eines 4 Bit breiten Datenbusses einen Ausschnitt aus einer Folge von Prüfbitmustern gemäß der Erfindung für den Fall, daß die Adreßleitung A4 des Adreßbusses einen "open 0" Fehler aufweist,

FIG 19 : am Beispiel eines 6 Bit breiten Adreßbusses und eines 4 Bit breiten Datenbusses einen Ausschnitt aus einer Folge von Prüfbitmustern gemäß der Erfindung für den Fall, daß die Adreßleitung A4 des Adreßbusses einen "open 1" Fehler aufweist,

FIG 20 : am Beispiel eines 6 Bit breiten Adreßbusses und eines 4 Bit breiten Datenbusses einen Ausschnitt aus einer Folge von Prüfbitmustern gemäß der Erfindung für den Fall, daß die Adreßleitung A5 des Adreßbusses einen "open 0" Fehler aufweist, und

FIG 21 : am Beispiel eines 6 Bit breiten Adreßbusses und eines 4 Bit breiten Datenbusses einen Ausschnitt aus einer Folge von Prüfbitmustern gemäß der Erfindung für den Fall, daß die Adreßleitung A5 des Adreßbusses einen "open 1" Fehler aufweist.

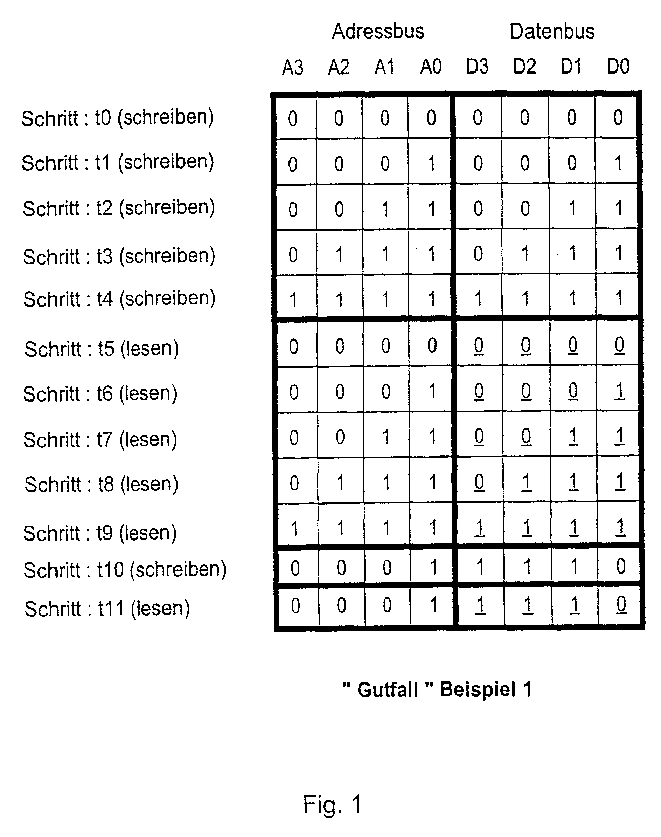

Das erfindungsgemäße Verfahren soll nachfolgend zunächst an Hand der Figur 1, 2 bis 5 und 6 bis 9 erläutert werden. Dabei zeigt Figur 1 einen sogenannten Gutfall am Beispiel eines jeweils 4 Bit breiten Adreß- und Datenbusses, d.h. eine Folge von Prüfbitmustern gemäß der Erfindung für den Fall, daß die Leitungen von Adreß- und Datenbus fehlerfrei sind.

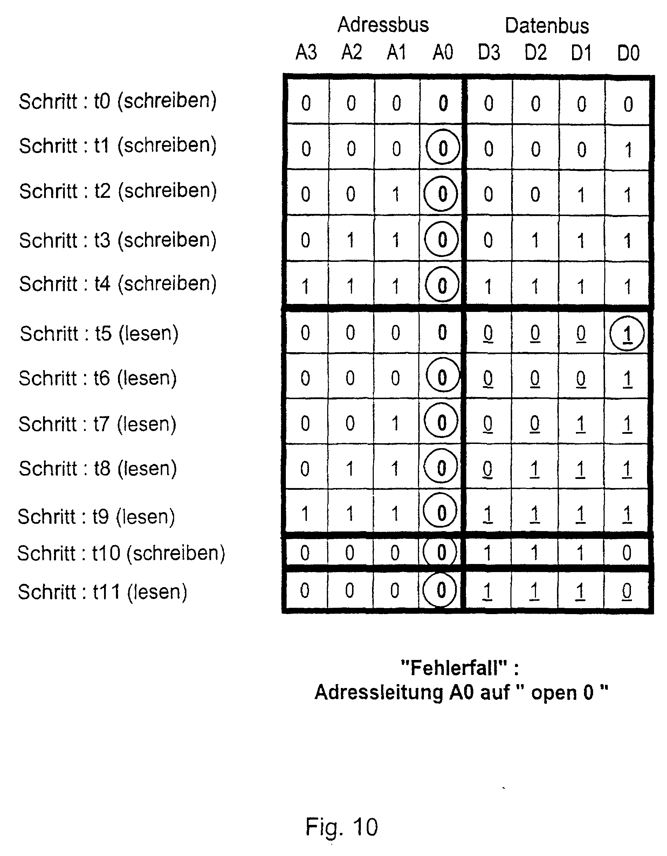

Bei dem dargestellten Beispiel sind nur fünf Schreibschritte t0 bis t4 und im Anschluß daran fünf Leseschritte t5 bis t9 notwendig, um die Fehlerfreiheit der Anschlüsse eines elektronischen Speicherbausteines feststellen zu können, welcher einen jeweils 4 Bit breiten Adreß- und Datenbus aufweist. Für den Fall, daß dabei ein sogenanntes Fehlerbild detektiert werden sollte, kann es gemäß einer vorteilhaften, weiteren Ausbildung der Erfindung vorteilhaft sein, einen weiteren Lese- und Schreibschritt durchzuführen. Diese sind im Beispiel der Figur 1 in Form des Schreibschrittes t10 und des Leseschrittes t11 zum Zweck der grundsätzlichen Erläuterung der Erfindung mit dargestellt, obwohl sie im vorliegenden Gutfall an sich nicht zwingend benötigt werden. Die mit jeweils einem zusätzlichen Schreib- und Leseschritt verbundenen Vorteile werden nachfolgend noch näher an den in den Figuren 10 bis 14 dargestellten Beispielen und den dabei auftretenden Fehlerbildern erläutert werden. Andererseits ist es in der Praxis aus Gründen der Vereinfachung ohne weiteres möglich, den zusätzlichen Schreib- und Leseschritt in jedem Fall unabhängig davon mit auszuführen, ob die vorangegangenen Schritte des erfindungsgemäßen Prüfverfahrens einem Gutfall oder einem Fehlerfall zugeordnet werden können.

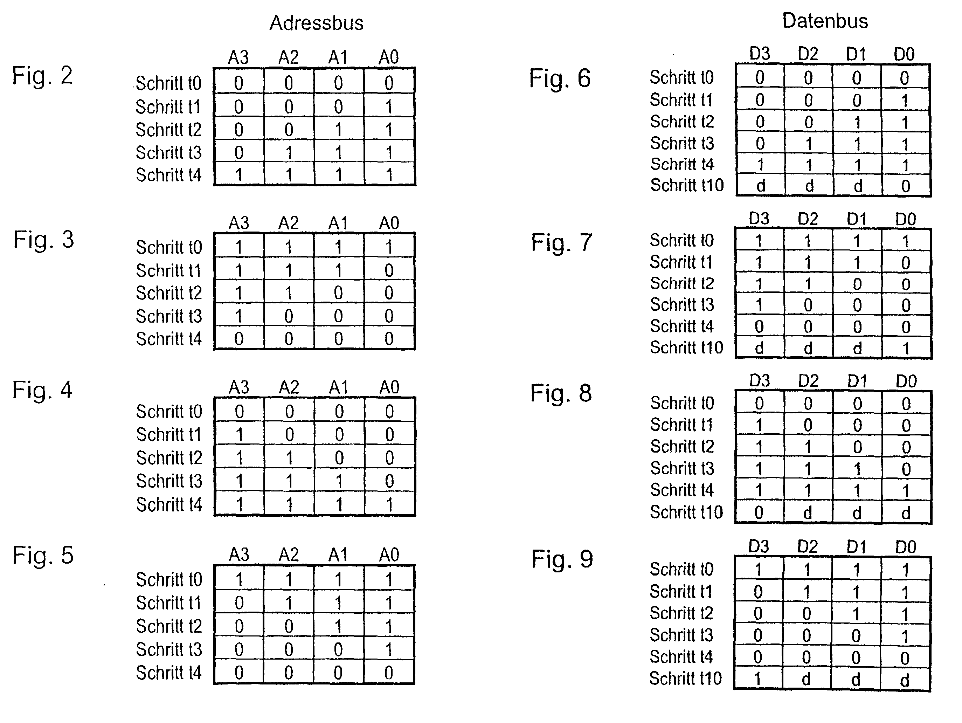

Erfindungsgemäß werden im Beispiel der Figur 1 im ersten Schritt t0 der Folge von Schreibschritten die vier Bits A0, A1, A2, A3 des Adreßbusses mit einem Adreßbitprüfmuster so belegt, daß alle Bits eine gleiche binäre Wertigkeit aufweisen, im Beispiel der Figur 1 die Wertigkeit 0000. Ferner werden im ersten Schritt t0 der Folge von Schreibschritten die vier Bits D0, D1, D2, D3 des Datenbusses mit einem Adreßbitprüfmuster so belegt, daß alle Bits ebenfalls eine gleiche binäre Wertigkeit aufweisen, im Beispiel der Figur 1 ebenfalls 0000. Bei anderen Ausführungen, welche nachfolgend noch am Beispiel der Figur 2 bis 9 erläutert werden, können auch andere Wertigkeiten im ersten Schritt t0 vorgegeben werden.

Erfindungsgemäß werden nun pro folgendem Schritt in der Folge der Schreibschritte t1, t2, t3, beginnend beim nieder- oder höchstwertigsten Bit im Adreß- und im Datenbitmuster, dem jeweils benachbarten Bit die im Vergleich zum vorangegangenen Schritt jeweils komplementäre binäre Wertigkeit zugeordnet, bis im letzten Schritt t4 der Folge von Schreibschritten alle Bits A0,A1,A2,A3 bzw. D0,D1,D2,D3 des Adreß- und Datenbusses eine zum jeweils ersten Schritt t0 komplementäre Wertigkeit aufweisen. Im Beispiel der Figur 1 hat dies zur Folge, daß in den Schreibschritten t1, t2, t3 die Adreßbitprüfmuster 0001, 0011, 0111 auf den Adreßbus und die Datenbitprüfmuster 0001, 0011, 0111 auf den Datenbus gegeben werden. Im letzten Schreibschritt t4 tritt dann als Adreß- und Datenbitprüfmuster die Kombination 1111 auf.

Es schließt sich nun eine Folge von Leseschritten t5 bis t9 an. Dabei entsprechen die in den einzelnen Leseschritten auf den Adreßbus ausgegebenen Adreßbitprüfmuster den in den vorangegangenen Schreibschritten t0 bis t4 ausgegebenen Adreßbitprüfmustern. Hiermit sollen die Datenbitprüfmuster, welche in die mit Hilfe der Adreßbitprüfmuster angesprochenen Zellen des elektronischen Schaltkreises eingeschrieben wurden, wieder ausgelesen werden. Die gelesenen Datenbitmuster D0,D1,D2,D3 des Datenbusses, welche in der Folge von Leseschritten t5 bis t9 das Leseergebnis anzeigen, sind in Figur 1 unterstrichen. In der gleichen Weise sind in allen folgenden Figuren Datenbitmuster, welche als Leseergebnis in der mindestens einen Folge von Leseschritten auf dem Datenbus auftreten, durch Unterstreichungen gekennzeichnet.

In einer weiteren, in den Figuren nicht näher dargestellten Folge von Prüfschritten werden nun die gelesenen Datenbitmuster mit den in der vorangegangenen Folge von Schreibschritten in den elektronischen Schaltkreis eingeschriebenen Datenbitprüfmustern verglichen. Treten bei einem derartigen Vergleich Abweichungen zwischen den Datenbitmustern und den Datenbitprüfmustern auf, so kann insbesondere mit Hilfe eines sogenannten Mustervergleiches die jeweils fehlerhafte Leitung auf dem Adreß- bzw. Datenbus lokalisiert werden. Bei einem Mustervergleich wird auf Adreß- bzw. Datenbitfehlermuster zurückgegriffen. Diese stellen eine Bibliothek von möglichen Fehlerbildern dar, bei deren Auftreten auf einen Defekt einer bestimmten Leitung des Adreß- bzw. Datenbusses geschlossen werden kann. Kann nun zumindest ein, von einem geschriebenen Datenbitfehlermuster abweichendes, gelesenes Datenbitmuster einem vorrätigen Adreß- bzw. Datenbitfehlermuster zugeordnet werden, so ist eine Lokalisierung der dazugehörigen fehlerhaften Adreß- bzw. Datenbusleitung möglich.

Im Beispiel der Figur 1 schließen sich noch ein zusätzlicher Schreibschritt t10, ein zusätzlicher Leseschritt t11 und ein nicht weiter dargestellter Prüfschritt an. Diese werden im Beispiel der Figur 1, wie oben bereits erläutert, an sich nicht benötigt, da es sich dabei um einen sogenannten "Gutfall" handelt. D.h. die in der Folge der Leseschritte t5 bis t9 erfaßten Datenbitmuster auf dem Datenbus sind identisch mit den in der Folge der Schreibschritte t0 bis t4 eingeschriebenen Datenbitprüfmustern. Da somit die Anschlüsse eines elektronischen Schaltkreises, insbesondere eines Speicherbausteines, an einen derartigen Adreß- und Datenbus fehlerfrei sind, sind die Schritte t10,t11 zwar nicht erforderlich, werden aber in der Praxis aus Gründen der Erleichterung des Prüfablaufes häufig mit durchlaufen.

Das Datenbitprüfmuster im Schreibschritt t10 wird dabei erfindungsgemäß so ausgewählt, daß zumindest das Bit des Datenbitprüfmusters die gleiche binäre Wertigkeit aufweist wie dasjenige Bit des Datenbitprüfmusters, dessen binäre Wertigkeit beim zweiten Schreibschritt im Vergleich zum ersten Schreibschritt komplementiert wurde. Im Beispiel der Figur 1 hat dies zur Folge, daß im zusätzlichen Schreibschritt t10 das Bit D0 des Datenbitprüfmusters die gleiche binäre Wertigkeit 0 aufweist wie das Bit D0 des Datenbitprüfmusters im ersten Schreibschritt t1, da dessen binäre Wertigkeit im Vergleich dazu beim zweiten Schreibschritt t2 komplementiert wurde. Am Beispiel der Figuren 6 bis 9 werden weitere Ausführungen für diesen zusätzlichen Schreib- und Leseschritt erläutert werden.

Unter Anwendung des erfindungsgemäßen Verfahrens können alle Verbindungen bevorzugt zu jedem Speicherbaustein auf das Vorliegen insbesondere von möglichen Unterbrechungen geprüft werden. Dabei können Fehler nicht nur detektiert, sondern auch eindeutig lokalisiert werden. Das erfindungsgemäße Verfahren zeichnet sich insbesondere dadurch aus, daß bei einer nur vergleichsweisen geringen Anzahl an Schreib- und Leseschritten eine entsprechend geringe Anzahl an Adreß- und Datenbitprüfmustern erforderlich ist. Mit dem erfindungsgemäßen Verfahren können ferner Kurzschlüsse zwischen Adreßleitungen und zwischen Datenleitungen insbesondere dann detektiert und lokalisiert werden, wenn die Breiten von Adreß- und Datenbus übereinstimmen. Besonders bei unterschiedlichen Adreß- und Datenbusbreiten kann es vorteilhaft sein, wenn vor Anwendung des erfindungsgemäßen Verfahrens eine Kurzschlußmessung an einigen wenigen, an ausgewählten oder allen Leitungen durchgeführt wird.

In den Figuren 2 bis 5 sind am Beispiel von jeweils 4 Bit breiten Adreßbussen mit den Bits A0,A1,A2,A3 und einer ersten Folge von Schreibschritten t0 bis t4 weitere, gemäß der Erfindung mögliche Folgen von Adreßbitprüfmustern dargestellt. In Figur 2 sind die Wertigkeiten des Adreßbitprüfmusters im ersten Schritt 0000, in den folgenden Schritten 0001, 0011, 0111 und im letzten Schritt 1111. In Figur 3 sind die Wertigkeiten des Adreßbitprüfmusters im ersten Schritt 1111, in den folgenden Schritten 1110, 1100, 1000 und im letzten Schritt 0000. In Figur 4 sind die Wertigkeiten des Adreßbitprüfmusters im ersten Schritt 0000, in den folgenden Schritten 1000, 1100, 1110 und im letzten Schritt 1111. In Figur 5 sind die Wertigkeiten des Adreßbitprüfmusters im ersten Schritt 1111, in den folgenden Schritten 0111, 0011, 0001 und im letzten Schritt 0000.

In den Figuren 6 bis 9 sind ebenfalls am Beispiel von jeweils 4 Bit breiten Datenbussen mit den Bits D0,D1,D2,D3 und einer ersten Folge von Schreibschritten t0 bis t4 einschließlich des zusätzlichen Schreibschrittes t10 weitere, gemäß der Erfindung mögliche Folgen von Datenbitprüfmustern dargestellt. In Figur 6 sind die Wertigkeiten des Datenbitprüfmusters im ersten Schritt 0000, in den folgenden Schritten 0001, 0011, 0111 und im letzten Schritt 1111. Dabei sollte im Schritt t10 zumindest das Datenbit D0 die Wertigkeit 0 aufweisen, während die Wertigkeiten der übrigen Bits D1,D2,D3 frei gewählt werden kann, was durch die Kennung "d" symbolisiert ist. In Figur 7 sind die Wertigkeiten des Datenbitprüfmusters im ersten Schritt 1111, in den folgenden Schritten 1110, 1100, 1000 und im letzten Schritt 0000. Dabei sollte im Schritt t10 zumindest das Datenbit D0 die Wertigkeit 1 aufweisen, während die Wertigkeiten der übrigen Bits D1,D2,D3 frei gewählt werden kann, was durch die Kennung "d" symbolisiert ist. In Figur 8 sind die Wertigkeiten des Datenbitprüfmusters im ersten Schritt 0000, in den folgenden Schritten 1000, 1100, 1110 und im letzten Schritt 1111. Dabei sollte im Schritt t10 zumindest das Datenbit D3 die Wertigkeit 0 aufweisen, während die Wertigkeiten der übrigen Bits D0,D1,D2 frei gewählt werden kann, was durch die Kennung "d" symbolisiert ist. In Figur 9 sind die Wertigkeiten des Datenbitprüfmusters im ersten Schritt 1111, in den folgenden Schritten 0111, 0011, 0001 und im letzten Schritt 0000. Dabei sollte im Schritt t10 zumindest das Datenbit D3 die Wertigkeit 1 aufweisen, während die Wertigkeiten der übrigen Bits D0,D1,D2 frei gewählt werden kann, was durch die Kennung "d" symbolisiert ist.

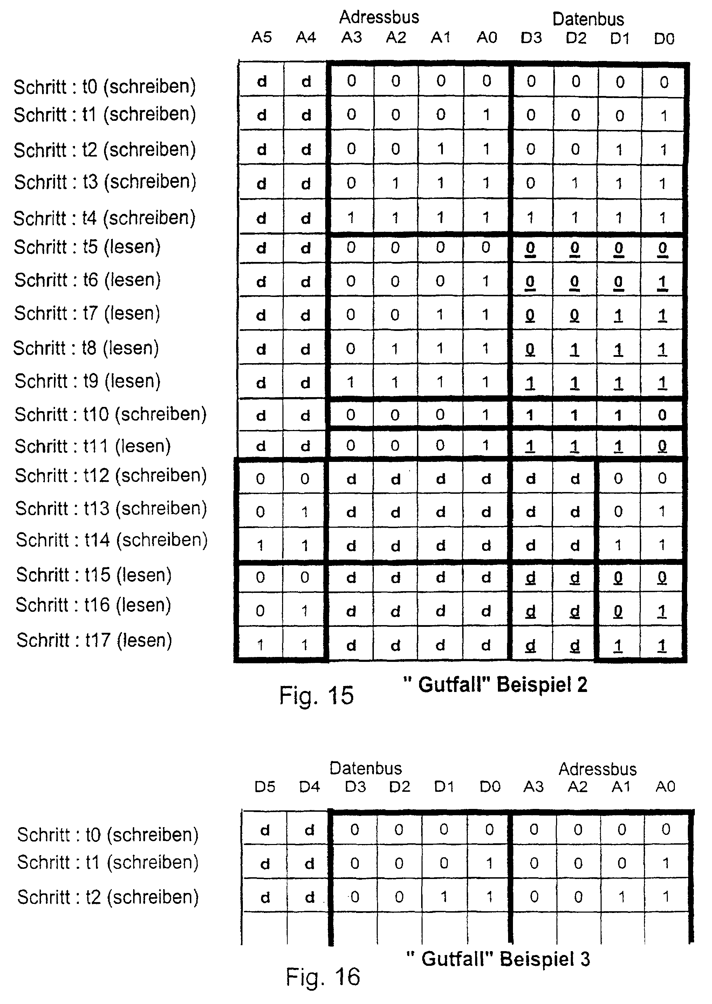

Es ist nun ohne weiteres möglich, die einerseits in den Figuren 2 bis 5 dargestellten Folgen von Adreßbitprüfmustern mit den in den Figuren 6 bis 9 dargestellten Folgen von Datenbitprüfmustern für einen Prüfvorgang beliebig zu kombinieren. So ist es beispielsweise möglich, daß in einer ersten Folge von Schreib- und Leseschritten die in Figur 3 dargestellten Adreßbitprüfmuster auf den Adreßbus eines zu prüfenden Speicherbausteines geschrieben werden, und in der dazugehörigen Folge von Schreibschritten die in Figur 8 dargestellten Datenbitprüfmuster. Ferner ist das erfindungsgemäße Verfahren auch bei Prüflingen anwendbar, deren Adreß- und Datenbusse beliebige Breiten aufweisen. Dies wird nachfolgend noch ausführlich an Hand der Figuren 15 bis 21 erläutert werden.

Mit Hilfe der nachfolgenden Figuren 10 bis 14 werden jeweils am Beispiel eines 4 Bit breiten Adreßbusses und eines 4 Bit breiten Datenbusses Folgen von Prüfbitmustern gemäß der Erfindung für den Fall erläutert, daß eine der Leitungen des Adreß- oder Datenbusses fehlerhaft ist. Als Fehlertypen sind beispielhaft die bereits erläuterten "open 0" und "open 1" dargestellt.

So zeigt Figur 10 eine Folge von Prüfbitmustern gemäß der Erfindung für den Fall, daß die Adreßleitung A0 des Adreßbusses einen "open 0" Fehler aufweist. Die bei einzelnen Schreib- und Leseschritten bei den Wertigkeiten auf den Leitungen A0, D0 des Adreß- und Datenbusses auftretenden, fehlerbedingten Abweichungen gegenüber dem "Gutfall" von Figur 1 sind durch Kreise gekennzeichnet. So verharrt A0 auf Grund des angenommenen "open 0" Fehlers dieser Leitung bei den Schritten t1 bis t4 und t6 bis t11 auf der binären Wertigkeit 0, statt die Wertigkeit 1 anzunehmen. Dies hat zur Folge, daß bei den Schritten t0,t1 und t5,t6 in fehlerhafter Weise die gleiche Speicherzelle angesprochen wird. Im Schritt t1 wird somit das Datenbitprüfmuster 0001 in diese Zelle geschrieben, und hierdurch das im vorangegangenen Schritt t0 eingeschriebene Datenbitprüfmuster 0000 überschrieben. Dieser Vorgang wird insbesondere im Leseschritt t5 detektiert, da dabei anstelle des Datenbitmusters 0000 das Datenbitmuster 0001 gelesen wird. Die Folge der in den Leseschritten t5 bis t9 und t11 erfaßten Datenbitmuster und deren Abweichung vom "Gutfall" der Figur 1, d.h. das dabei auftretende Fehlerbild, ist charakteristisch für einen Fehler auf der Adreßbusleitung A0. Dieser kann in einer Folge von Prüfschritten, z.B. durch einen Mustervergleich der erfaßten Datenbitmuster mit einer Bibliothek von Datenbitfehlermustern, detektiert werden.

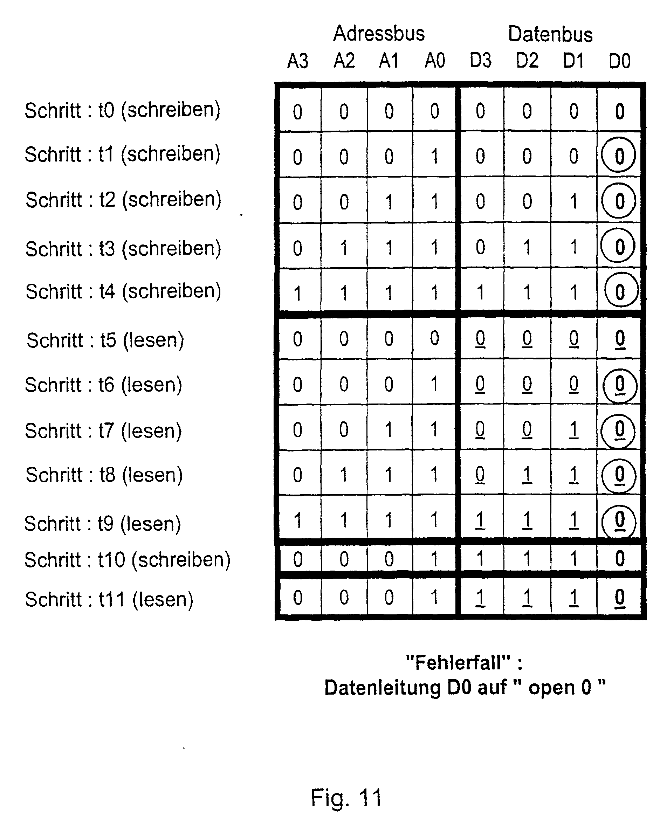

Ferner zeigt Figur 11 eine die Folge von Prüfbitmustern gemäß der Erfindung für den Fall, daß die Datenleitung D0 des Datenbusses einen "open 0" Fehler aufweist. Die bei einzelnen Schreib- und Leseschritten bei den Wertigkeiten auf der Leitung D0 des Datenbusses auftretenden, fehlerbedingten Abweichungen gegenüber dem "Gutfall" von Figur 1 sind durch Kreise gekennzeichnet. So verharrt D0 auf Grund des angenommenen "open 0" Fehlers dieser Leitung bei den Schritten t1 bis t4 und t6 bis t9 auf der binären Wertigkeit 0, statt die Wertigkeit 1 anzunehmen. Dies hat zur Folge, daß bei den Schritten t1 bis t4 in fehlerhafter Weise Datenbitprüfmuster 0000, 0010, 0110, 1110 anstelle der Datenbitprüfmuster 0001, 0011, 0111, 1111 in die jeweils adressierten Zellen geschrieben werden. Dieser Vorgang wird insbesondere in den Leseschritten t5 bis t9 und t11 detektiert. Die Folge der in den Leseschritten t5 bis t9 und t11 erfaßten Datenbitmuster und deren Abweichung vom "Gutfall" der Figur 1, d.h. das dabei auftretende Fehlerbild, ist charakteristisch für einen Fehler auf der Datenbusleitung D0. Dieser kann in einer Folge von Prüfschritten, z.B. durch einen Mustervergleich der erfaßten Datenbitmuster mit einer Bibliothek von Datenbitfehlermustern, detektiert werden.

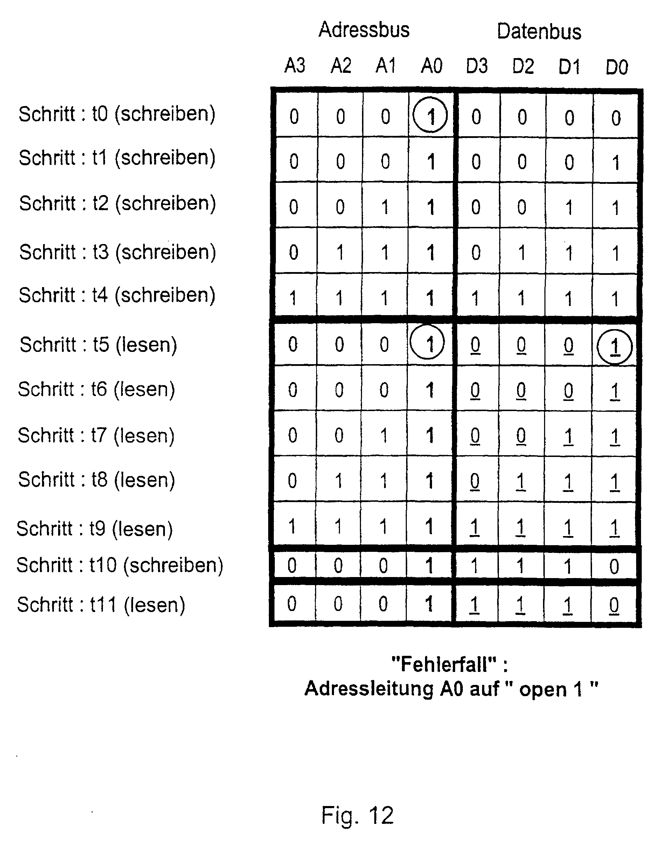

Desweiteren zeigt Figur 12 eine die Folge von Prüfbitmustern gemäß der Erfindung für den Fall, daß die Adreßleitung A0 des Adreßbusses einen "open 1" Fehler aufweist. Die bei einzelnen Schreib- und Leseschritten bei den Wertigkeiten auf der Leitungen A0, D0 des Adreß- und Datenbusses auftretenden, fehlerbedingten Abweichungen gegenüber dem "Gutfall" von Figur 1 sind durch Kreise gekennzeichnet. So verharrt A0 auf Grund des angenommenen "open 1" Fehlers dieser Leitung bei den Schritten t0 und t5 auf der binären Wertigkeit 1, statt die Wertigkeit 0 anzunehmen. Dies hat zur Folge, daß bei den Schritten t0,t1 und t5,t6 und t10,t11 in fehlerhafter Weise die gleiche Speicherzelle angesprochen wird. Im Schritt t1 wird somit das Datenbitprüfmuster 0001 in diese Zelle geschrieben, und hierdurch das im vorangegangenen Schritt t0 eingeschriebene Datenbitprüfmuster 0000 überschrieben. Dieser Vorgang wird insbesondere im Leseschritt t5 detektiert, da dabei anstelle des Datenbitmusters 0000 das Datenbitmuster 0001 gelesen wird. Die Folge der in den Leseschritten t5 bis t9 und t11 erfaßten Datenbitmuster und deren Abweichung vom "Gutfall" der Figur 1, d.h. das dabei auftretende Fehlerbild, ist charakteristisch für einen Fehler auf der Adreßbusleitung A0. Dieser kann in einer Folge von Prüfschritten, z.B. durch einen Mustervergleich der erfaßten Datenbitmuster mit einer Bibliothek von Datenbitfehlermustern, detektiert werden.

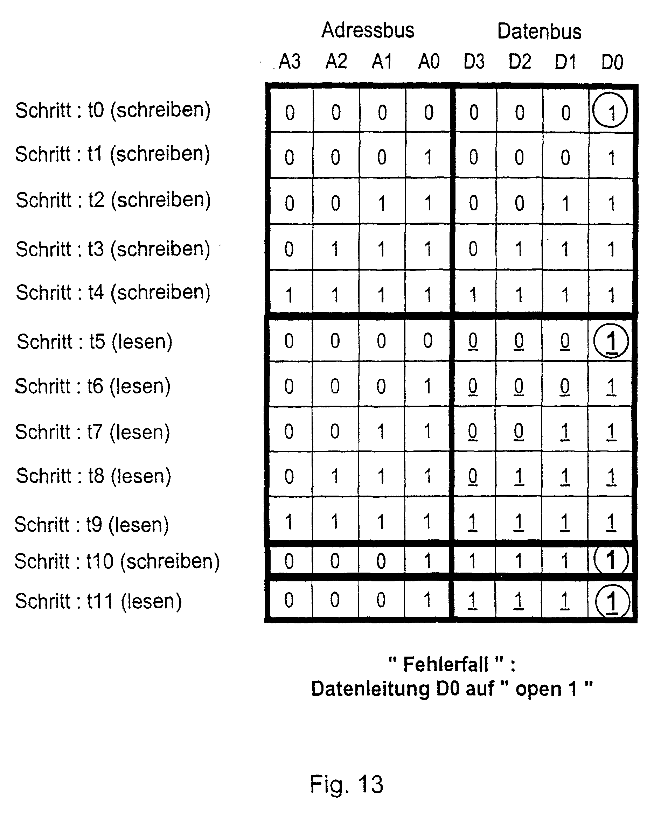

Ferner zeigt Figur 13 eine die Folge von Prüfbitmustern gemäß der Erfindung für den Fall, daß die Datenleitung D0 des Datenbusses einen "open 1" Fehler aufweist. Die bei einzelnen Schreib- und Leseschritten bei den Wertigkeiten auf der Leitung D0 des Datenbusses auftretenden, fehlerbedingten Abweichungen gegenüber dem "Gutfall" von Figur 1 sind durch Kreise gekennzeichnet. So verharrt D0 auf Grund des angenommenen "open 1" Fehlers dieser Leitung bei den Schritten t5, t10 und t11 auf der binären Wertigkeit 1, statt die Wertigkeit 0 anzunehmen. Dies hat zur Folge, daß bei den Schritten t0 und t10 in fehlerhafter Weise die Datenbitprüfmuster 0001 und 1111 anstelle der Datenbitprüfmuster 0000 und 1110 in die jeweils adressierten Zellen geschrieben werden. Dieser Vorgang wird insbesondere in den Leseschritten t5 und t11 detektiert. Die Folge der in den Leseschritten t5 bis t9 und t11 erfaßten Datenbitmuster und deren Abweichung vom "Gutfall" der Figur 1, d.h. das dabei auftretende Fehlerbild, ist charakteristisch für einen Fehler auf der Datenbusleitung D0. Dieser kann in einer Folge von Prüfschritten, z.B. durch einen Mustervergleich der erfaßten Datenbitmuster mit einer Bibliothek von Datenbitfehlermustern, detektiert werden.

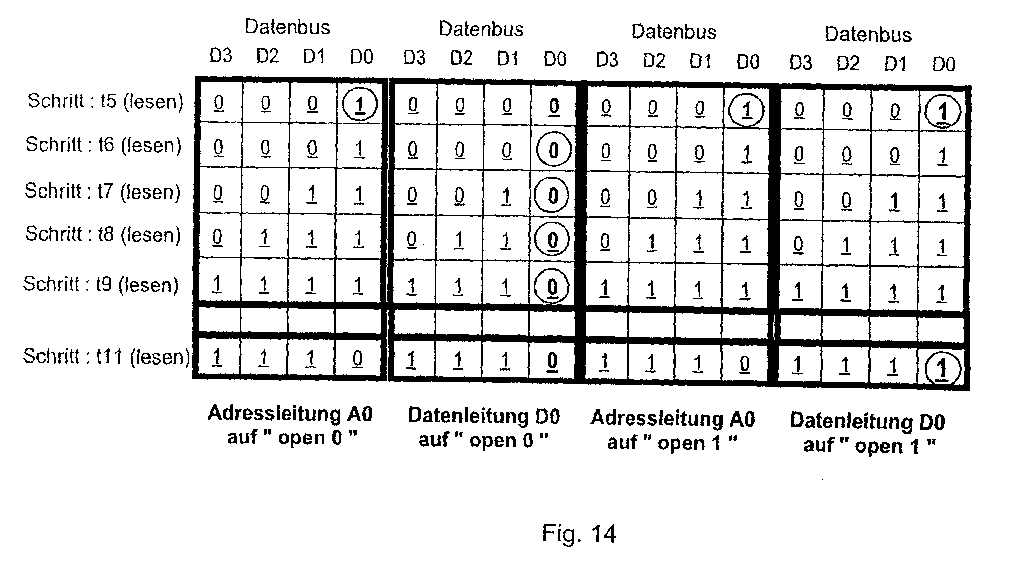

Schließlich zeigt Figur 14 eine Zusammenstellung der in den Beispielen der Figuren 10,11,12,13 in Form der in den Schritten t5 bis t9 und t11 gelesenen Datenbitmuster erfaßten Fehlerbilder I, II, III, IV. Es ist ersichtlich, daß die Datenbitmuster der vier Fälle unterschiedlich sind. In einer Folge von Prüfschritten kann somit unabhängig davon, welcher Fehlertyp vorliegt, d.h. unabhängig davon ob ein "open 0", "open 1", "stuck-at 0" oder "stuck-at 1" Fehler vorliegt, die von dem Fehler betroffene Leitung eindeutig identifiziert werden. Diese Leitung ist nun einer Reparatur zugänglich.

Das erfindungsgemäße Verfahren ermöglicht es natürlich in gleicher Weise fehlerhafte Verbindungen auch bei den anderen Adreß- und Datenleitungen A1, A2, A3 und D1, D2, D3 der in den Beispielen der Figuren 1 bis 14 dargestellten Adreß- und Datenbusse zu erkennen und eindeutig zu lokalisieren.

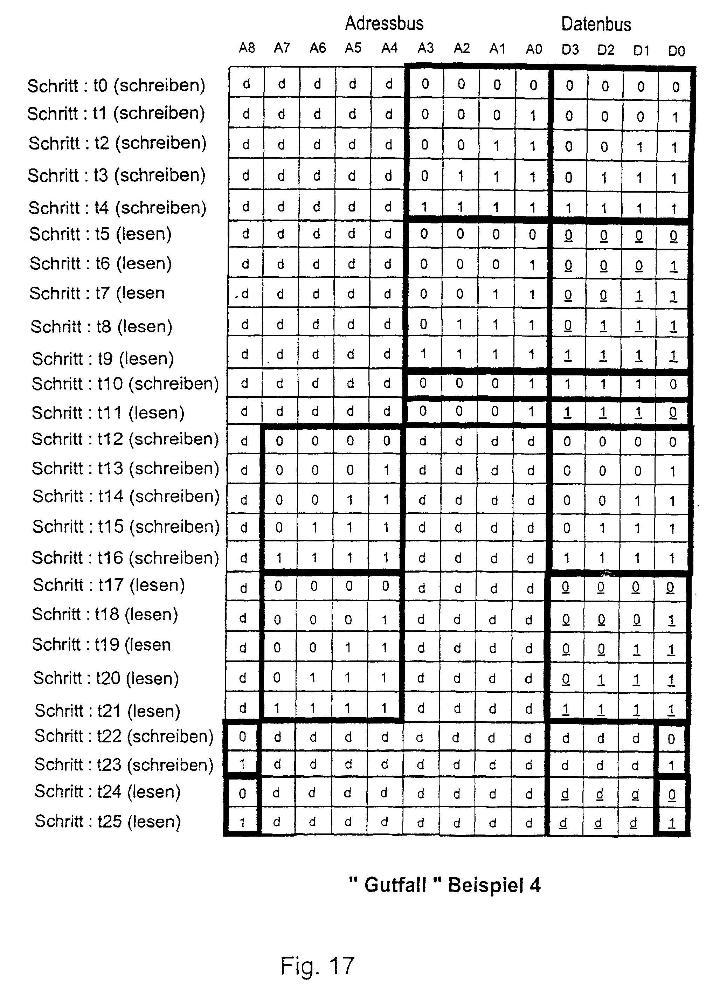

Das erfindungsgemäße Verfahren ist ferner uneingeschränkt insbesondere bei beschreibbaren Speicherbausteinen mit Adreß- und Datenbussen anwendbar, welche unterschiedliche Busbreiten aufweisen. Dies wird nachfolgend an den in den Figuren 15 bis 21 dargestellten Beispielen näher erläutert. So zeigen die Figuren 15, 16, 17 Beispiele von sogenannten "Gutfällen" von Adreß- und Datenbussen mit unterschiedlichen Busbreiten, d.h. von Adreß- und Datenbussen mit fehlerfreien Leitungen. Dabei zeigt Figur 15 am Beispiel eines 6 Bit breiten Adreßbusses und eines 4 Bit breiten Datenbusses, Figur 16 am Beispiel eines 6 Bit breiten Datenbusses und eines 4 Bit breiten Adreßbusses und Figur 17 am Beispiel eines 9 Bit breiten Adreßbusses und eines 4 Bit breiten Datenbusses jeweils eine Folge von Adreß- und Datenbitprüfmustern gemäß der Erfindung.

Im Beispiel der Figur 15 weist der Adreßbus die Bits A0, A1 bis A5 und der Datenbus die Bits D0, D1 bis D3 auf. Der Adreßbus verfügt somit über eine größere Busbreite als der Datenbus. Bei dem Prüfverfahren gemäß der Erfindung werden in einer ersten Folge von Schreibschritten t0 bis t4 zunächst alle Bits D0 bis D3 des Datenbusses und diejenigen Bits des Adreßbusses, welche zu den Bits des Datenbusses korrespondierende Wertigkeiten aufweisen, d.h. die Bits A0 bis A3, mit Adreß- und Datenbitprüfmustern belegt. Es schließt sich dann eine Folge von Leseschritten t5 bis t9 an, wobei auf die gleiche Auswahl von Bits des Adreß- und Datenbusses zugegriffen wird wie bei den vorangegangenen Schreibschritten. Vorteilhaft schließt sich vorteilhaft dann noch ein zusätzlicher Schreibschritt t10 und ein zusätzlicher Leseschritt t11 an.

Diejenigen Bits des Adreßbusses, welche eine Wertigkeit aufweisen, die größer ist als die Wertigkeit des höchstwertigsten Bits des Datenbusses, im Beispiel der Figur 15 die Adreßbits A4, A5, werden in dieser Phase der Prüfung noch nicht betrachtet. Sie sind folglich in Figur 15 mit einem "d", d.h. einem "don't care" Symbol belegt. Damit wird eine beliebige binäre Wertigkeit gekennzeichnet. Es ist vorteilhaft, wenn in jedem der Schreibschritte t0 bis t4 diese Wertigkeiten einmal fest vorgegeben werden, und insbesondere zumindest für die folgenden Leseschritte t5 bis t9 konstant gehalten werden.

Bis einschließlich Schritt t11 entspricht der Verfahrensablauf dem Beispiel von Figur 1 und wird somit nicht nochmals erläutert. Kann bis dahin kein Fehlerbild erkannt werden, so sind die Bits A0 bis A3 und D0 bis D3 geprüft und können als fehlerfrei angesehen werden.

Erfindungsgemäß wird nun zur Überprüfung von Bits des Adreßbzw. Datenbusses, welche eine die Wertigkeit des jeweils höchstwertigsten Bits des Daten- bzw. Adreßbusses übersteigende Wertigkeit aufweisen, zumindest eine zweite Folge von Schreib-, Lese- und Prüfschritten durchlaufen. Da im Beispiel der Figur 15 der Adreßbus eine den Datenbus übersteigende Wertigkeit aufweist, müssen noch die Adreßbits A4 und A5 geprüft werden. Hierzu ist eine zweite Folge von Schreibschritten t12, t13, t14, eine zweite Folge von Leseschritten t15, t16, t17 und eine nicht näher dargestellte Folge von Prüfschritten erforderlich.

Dabei werden diejenigen Bits des Adreß- bzw. Datenbusses mit gemäß der Erfindung ausgewählten Adreß- und Datenbitprüfmustern belegt, welche die übersteigende Wertigkeit aufweisen. Ferner werden diejenigen benachbarten Bits des Daten- bzw. Adreßbusses mit gemäß der Erfindung ausgewählten Adreß- und Datenbitprüfmustern belegt, welche in der ersten Folge von Schreib-, Lese- und Prüfschritten bereits mit Adreß- bzw. Datenbitprüfmustern belegt wurden und deren Anzahl, beginnend beim jeweils nieder- oder höchstwertigsten Bit dieser Gruppe, der Anzahl der Bits mit der übersteigenden Wertigkeit entspricht. Im Beispiel der Figur 15 hat dies zur Folge, daß in den Schreibschritten t12, t13, t14 die Bits A4, A5 des Adreßbusses mit Adreßbitprüfmustern und die Bits D0, D1 des Datenbusses mit Datenbitprüfmustern belegt werden. Da die übrigen Bits bereits geprüft sind, ist deren binäre Wertigkeit beliebig, was in Figur 15 wiederum durch "d" Kennungen symbolisiert ist. In den anschließenden Leseschritten t15, t16 wird auf die gleichen Bits von Adreß- und Datenbus zugegriffen. Im Anschluß daran kann in einer weiteren Folge von Prüfschritten überprüft werden, ob Fehlerbilder aufgetreten sind. Diese können dann zur Lokalisierung eines möglichen Fehlers auf einer der Adreßleitungen A0, A1 insbesondere mit Datenbitfehlermustern verglichen werden. Die Prüfung der Bits A4, A5 ist mit einem Fall vergleichbar, bei dem Adreß- und Datenbus eine übereinstimmende Wortbreite aufweisen, im Beispiel der Figur 15 also die Breite zwei mit den Bits Ay, Az, Dy, Dz.

Im Beispiel der Figur 16 ist der Datenbus 6 Bit und der Adreßbus 4 Bit breit. Da dabei das Prüfverfahren weitgehend vergleichbar zu dem in Figur 15 dargestellten Fall abläuft, sind in Figur 16 aus Vereinfachungsgründen auszugsweise nur die ersten drei Schreibschritte t0, t1, t2 dargestellt.

Schließlich zeigt Figur 17 am Beispiel eines 9 Bit breiten Adreßbusses mit den Bits A0 bis A8 und eines 4 Bit breiten Datenbusses mit den Bits D0 bis D3 eine weitere Folge von Adreß- und Datenbitprüfmustern gemäß der Erfindung. Auch hier entspricht der Ablauf des Prüfverfahrens in den Schritten t0 bis t11 dem Beispiel von Figur 1. Es werden bei diesen Folgen von Schreib-, Lese- und Prüfschritten die Bits A0 bis A3 des Adreßbusses und die Bits D0 bis D3 des Datenbusses überprüft. Die Bits A4 bis A8 des Adreßbusses mit höherer Wertigkeit werden in dieser Phase noch nicht betrachtet, und sind in Figur 17 wiederum mit "d" belegt. Sind die Bits A0 bis A3 und D0 bis D3 von Adreß- und Datenbus fehlerfrei, schließt sich zunächst eine zweite Folge von Schreibschritten t12 bis t16, eine zweite Folge von Leseschritten t17 bis t21 und zweite Folge von nicht näher dargestellten Prüfschritten an. Dabei werden zur Prüfung der Adreßbits A4 bis A7 diese Bits und die Bits D0 bis D3 des Datenbusses in einer den bisherigen Erläuterungen entsprechenden Weise mit gemäß der Erfindung ausgewählten Adreß- und Datenbitprüfmustern belegt. Das Bit A8 des Adreßbusses mit höherer Wertigkeit wird in dieser Phase noch nicht betrachtet. Ferner werden die bereits geprüften Bits A0 bis A3 des Adreßbusses in dieser Phase nicht mehr betrachtet. Alle diese Bits sind in Figur 17 somit ebenfalls mit "d" belegt. Sind die Bits A4 bis A7 des Adreßbusses fehlerfrei, so schließen sich eine letzte Folge von zwei Schreibschritten t22, t23, eine letzte Folge von zwei Leseschritten t24, t25 und eine letzte Folge von nicht näher dargestellten Prüfschritten an. Diese dienen zur Prüfung des höchstwertigsten Adreßbits A8. Hierbei sind in Figur 17 die Bits D1 bis D3 und A0 von A7 mit "d" belegt, da diese in den vorangegangenen Schritten bereits geprüft wurden.

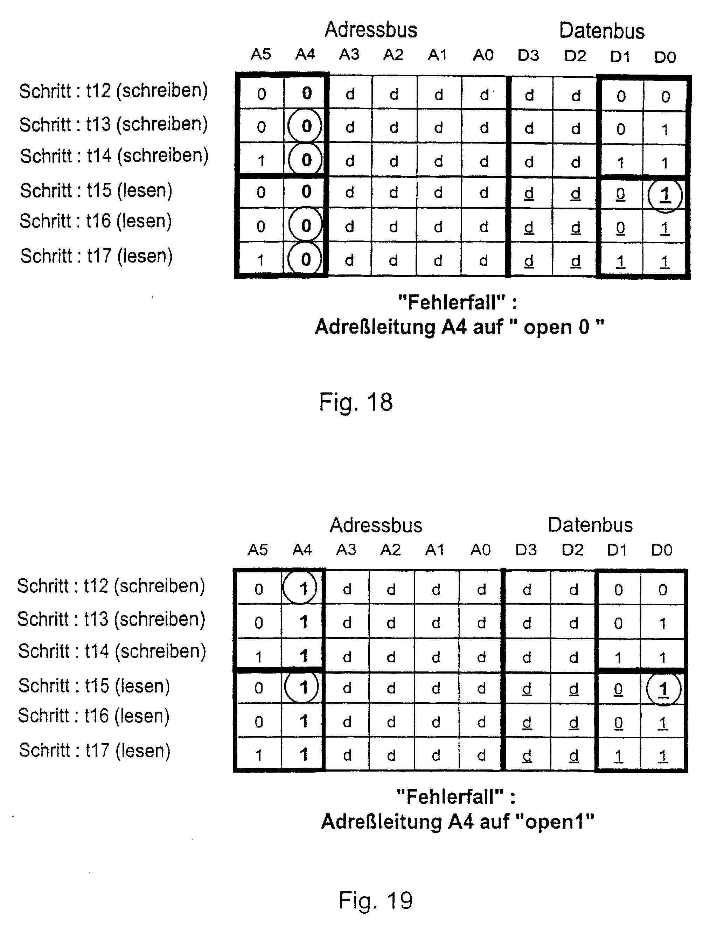

In den Figuren 18 bis 21 werden schließlich jeweils am Beispiel eines 6 Bit breiten Adreßbusses und eines 4 Bit breiten Datenbusses die Prüfungen derjenigen Adreßleitungen gezeigt, welche eine die Wertigkeit des höchstwertigsten Bits D3 des Datenbusses übersteigende Wertigkeit aufweisen. In den Figuren 18 bis 21 sind dies die Adreßbits A4, A5, welche mittels einer zweiten Folge von Schreibschritten t12, t13, t14 und einer zweiten Folge von Leseschritten t15, t16, t17 geprüft werden. Es wird dabei vorausgesetzt, daß die Adreßbits A0 bis A3 und die Datenbits D0 bis D3 in jeweils einer ersten Folge von Lese-, Schreib- und Prüfschritten geprüft und fehlerfrei sind. Diese ersten Folgen entsprechen den Schritten t0 bis t11 der z.B. in den Figuren 1 bzw. 15 dargestellten Beispielen, und müssen somit nicht nochmals erläutert werden.

Bei den in den Figuren 18 bis 21 dargestellten Beispielen ist angenommen, daß die zu einem der beiden Adreßbits A4 bzw. A5 gehörige Leitung bzw. deren Anschluß an den dazugehörigen elektronischen Schaltkreis einen Fehler aufweist. Als Fehlertypen sind beispielhaft wiederum die bereits erläuterten "open 0" und "open 1" Fehler ausgewählt. Ferner sind die bei einzelnen Schreib- und Leseschritten auf den Bits der Leitungen A4, A5, D0, D1 des Adreß- und Datenbusses auftretenden, fehlerbedingten Abweichungen gegenüber dem z.B. in Figur 1 dargestellten "Gutfall" wiederum durch Kreise gekennzeichnet.

So zeigt Figur 18 einen Ausschnitt aus einer Folge von Prüfbitmustern gemäß der Erfindung für den Fall, daß die Adreßleitung A4 des Adreßbusses einen "open 0" Fehler aufweist. So verharrt A4 auf Grund des angenommenen Fehlers dieser Leitung bei den Schritten t13, t14 und t16, t17 auf der binären Wertigkeit 0, statt die Wertigkeit 1 anzunehmen. Dies hat zur Folge, daß bei den Schritten t12, t13 und t15, t16 in fehlerhafter Weise die gleiche Speicherzelle angesprochen wird. Im Schritt t13 wird somit das Datenbitprüfmuster dd01 in diese Zelle geschrieben, und hierdurch das im vorangegangenen Schritt t12 eingeschriebene Datenbitprüfmuster dd00 überschrieben. Dieser Vorgang wird insbesondere im Leseschritt t15 detektiert, da dabei anstelle des Datenbitmusters dd00 das Datenbitmuster dd01 gelesen wird. Die Folge der in den Leseschritten t15 bis t17 erfaßten Datenbitmuster und deren Abweichung vom "Gutfall" z.B. der Figur 1, d.h. das dabei auftretende Fehlerbild, ist charakteristisch für einen Fehler auf der Adreßbusleitung A4. Dieser kann in einer Folge von Prüfschritten, z.B. durch einen Mustervergleich der erfaßten Datenbitmuster mit einer Bibliothek von Datenbitfehlermustern, detektiert werden.

Ferner zeigt Figur 19 einen Ausschnitt aus einer Folge von Prüfbitmustern gemäß der Erfindung für den Fall, daß die Adreßleitung A4 des Adreßbusses einen "open 1" Fehler aufweist. So verharrt A4 auf Grund des angenommenen Fehlers dieser Leitung bei den Schritten t12 und t15 auf der binären Wertigkeit 1, statt die Wertigkeit 0 anzunehmen. Auch dies hat zur Folge, daß bei den Schritten t12, t13 und t15, t16 in fehlerhafter Weise die gleiche Speicherzelle angesprochen wird. Im Schritt t13 wird somit wiederum das Datenbitprüfmuster dd01 in diese Zelle geschrieben, und hierdurch das im vorangegangenen Schritt t12 eingeschriebene Datenbitprüfmuster dd00 überschrieben. Dieser Vorgang wird insbesondere im Leseschritt t15 detektiert, da dabei anstelle des Datenbitmusters dd00 das Datenbitmuster dd01 gelesen wird. Die Folge der in den Leseschritten t15 bis t17 erfaßten Datenbitmuster und deren Abweichung vom "Gutfall" z.B. der Figur 1, d.h. das dabei auftretende Fehlerbild, ist ebenfalls charakteristisch für einen Fehler auf der Adreßbusleitung A4.

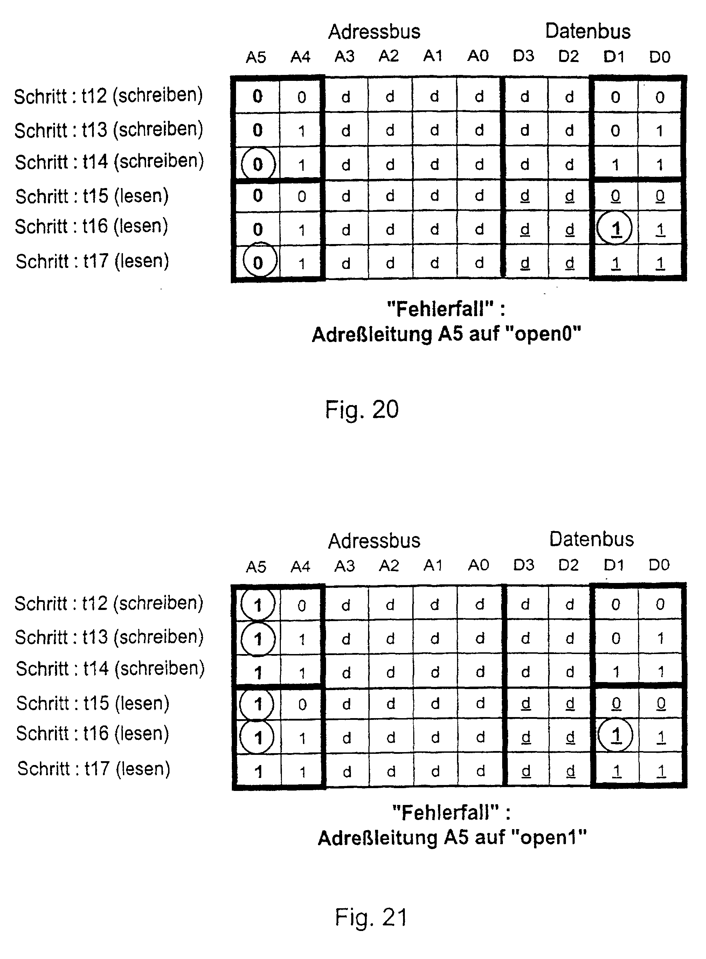

Ferner zeigt Figur 20 einen Ausschnitt aus einer Folge von Prüfbitmustern gemäß der Erfindung für den Fall, daß die Adreßleitung A5 des Adreßbusses einen "open 0" Fehler aufweist. So verharrt A5 auf Grund des angenommenen Fehlers dieser Leitung bei den Schritten t14 und t17 auf der binären Wertigkeit 0, statt die Wertigkeit 1 anzunehmen. Dies hat zur Folge, daß bei den Schritten t13, t14 und t16, t17 in fehlerhafter Weise die gleiche Speicherzelle angesprochen wird. Im Schritt t14 wird somit das Datenbitprüfmuster dd11 in diese Zelle geschrieben, und hierdurch das im vorangegangenen Schritt t13 eingeschriebene Datenbitprüfmuster dd01 überschrieben. Dieser Vorgang wird insbesondere im Leseschritt t16 detektiert, da dabei anstelle des Datenbitmusters dd01 das Datenbitmuster dd11 gelesen wird. Die Folge der in den Leseschritten t15 bis t17 erfaßten Datenbitmuster und deren Abweichung vom "Gutfall" z.B. der Figur 1, d.h. das dabei auftretende Fehlerbild, ist charakteristisch für einen Fehler auf der Adreßbusleitung A5.

Schließlich zeigt Figur FIG 21 einen Ausschnitt aus einer Folge von Prüfbitmustern gemäß der Erfindung für den Fall, daß die Adreßleitung A5 des Adreßbusses einen "open 1" Fehler aufweist. So verharrt A5 auf Grund des angenommenen Fehlers dieser Leitung bei den Schritten t12, t13 und t15, t16 auf der binären Wertigkeit 1, statt die Wertigkeit 0 anzunehmen. Dies hat zur Folge, daß bei den Schritten t13, t14 und t16, t17 in fehlerhafter Weise die gleiche Speicherzelle angesprochen wird. Im Schritt t14 wird somit das Datenbitprüfmuster dd11 in diese Zelle geschrieben, und hierdurch das im vorangegangenen Schritt t13 eingeschriebene Datenbitprüfmuster dd01 überschrieben. Dieser Vorgang wird insbesondere im Leseschritt t16 detektiert, da dabei anstelle des Datenbitmusters dd01 das Datenbitmuster dd11 gelesen wird. Die Folge der in den Leseschritten t15 bis t17 erfaßten Datenbitmuster und deren Abweichung vom "Gutfall" z.B. der Figur 1, d.h. das dabei auftretende Fehlerbild, ist charakteristisch für einen Fehler auf der Adreßbusleitung A5.

Für den in der Praxis häufig auftretenden Fall, daß der Adreßbus eine Breite aufweist, die größer oder gleich der Breite des Datenbusses ist, kann die bei Anwendung des erfindungsgemäßen Verfahrens erforderliche Anzahl AN an schreibenden und lesenden Zugriffen auf den zu überprüfenden Schaltkreis bestimmt werden mit der Beziehung

$$AN = 2\{ABB + 1\} + 2 + \begin{cases} 0 & \textit{für } ABB = DBB \\ 2 & \textit{für } DBB < ABB \leq 2DBB \\ 4 & \textit{für } 2DBB < ABB < 3DBB \end{cases}$$

mit

ABB = Adreßbusbreite
DBB = Datenbusbreite.

Im Falle DBB ≥ ABB, d.h. daß der Datenbus eine Breite aufweist, die größer oder gleich der Breite des Adreßbusses ist, müssen in obiger Gleichung die Faktoren DBB und ABB vertauscht werden.

**Patentansprüche**

1. Verfahren zur Überprüfung der Kontaktanschlüsse eines schreib- und lesbaren integrierten, elektronischen Schaltkreises, insbesondere eines Speicherbausteins, an einem Adreß- und einem Datenbus, wobei

    A. in mindestens einer ersten Folge von Schreibschritten (t0...t4) der Adreßbus (A0,A1,.) schrittweise mit ausgewählten Adreßbitprüfmustern (.,0011,.) belegt wird und ausgewählte Datenbitprüfmuster (.,1100,.) auf dem Datenbus (D0,D1,.) in den Schaltkreis geschrieben werden,

    B. in mindestens einer ersten Folge von Leseschritten (t5...t9) der Adreßbus (A0,A1,.) wiederum schrittweise mit den ausgewählten Adreßbitprüfmustern (.,0011,.) belegt wird und die dazugehörigen Datenbitmuster (., 1100,.) auf dem Datenbus (D0,D1,.) aus dem Schaltkreis gelesen werden,

    C. in mindestens einer ersten Folge von Prüfschritten die gelesenen Datenbitmuster mit den ausgewählten Datenprüfbitmustern verglichen werden und bei Abweichungen, insbesondere durch Mustervergleich mit Adreß- und Datenbitfehlermustern, die fehlerhafte Leitung auf dem Adreßbus (A0,A1,.) bzw. Datenbus (D0,D1,.) lokalisiert wird,
    **dadurch gekennzeichnet, daß**

    D. Adreß- und Datenbitprüfmuster so ausgewählt sind, daß

        i) in einem ersten Schritt der ersten Folge von Schreib- bzw. Leseschritten (t0 bzw. t5) die Bits des Adreßbitprüfmusters eine erste, übereinstimmende binäre Wertigkeit (0000 bzw. 1111) aufweisen, und

ii) im ersten Schritt der ersten Folge von Schreibschritten (t0) die Bits des Datenbitprüfmusters eine zweite, übereinstimmende binäre Wertigkeit (0000 bzw. 1111) aufweisen, und

iii) pro folgendem Schritt der jeweiligen Folge von Schreib- bzw. Leseschritten (t1,t2,t3 bzw. t6,t7,t8) beginnend beim nieder- oder höchstwertigsten Bit im Adreß- bzw. Datenbitprüfmuster, dem jeweils benachbarten Bit die im Vergleich zum vorangegangenen Schritt (.,0011,. bzw. .,1100,.) jeweils komplementäre binäre Wertigkeit zugeordnet wird (.,0111,. bzw. .,1000,.), bis

iv) in einem letzten Schritt der Folge von Schreibbzw. Leseschritten (t4;t9) alle Bits des Adreßbzw. Datenbitprüfmusters eine zum jeweiligen ersten Schritt komplementäre binäre Wertigkeit (1111 bzw. 0000) aufweisen.

**2.** Verfahren nach Anspruch 1, wobei zur Überprüfung von Bits des Adreßbusses (A5,A4) bzw. des Datenbusses (D5,D4), welche eine die Wertigkeit des jeweils höchstwertigsten Bits des Datenbusses (D3) bzw. des Adreßbusses (A3) übersteigende Wertigkeit aufweisen,

A. zumindest eine zweite Folge (t12...t17) von Schreib-, Lese- und Prüfschritten durchlaufen wird, und dabei

B. mit ausgewählten Adreß- und Datenbitprüfmustern belegt werden

i) diejenigen Bits des Adreß- bzw. Datenbusses (A5,A4; D5,D4), welche die übersteigende Wertigkeit aufweisen, und
ii) diejenigen benachbarten Bits des Daten- bzw. Adreßbusses (D1,D0;), welche

a) in der ersten Folge von Schreib-, Lese- und Prüfschritten (t0...t9) bereits mit Adreßbzw. Datenbitprüfmustern belegt wurden, und

b) deren Anzahl, beginnend beim jeweils niederoder höchstwertigsten Bit dieser Gruppe, der Anzahl der Bits mit der übersteigenden Wertigkeit entspricht.

**3.** Verfahren nach Anspruch 1 oder 2, wobei

A) im Anschluß an die erste Folge von Schreib-, Lese- und Prüfschritten (t0...t9) für dieselben Adreß- und Datenbusbits (A0,A1, ...;D0, D1, ...) jeweils ein zusätzlicher Schreib-, Lese- und Prüfschritt (t10,t11) durchführt wird, und dabei zumindest

B) das Datenbitprüfmuster so ausgewählt wird, daß in dem zusätzlichen Schreibschritt (t10) zumindest das Bit (D0) des Datenbitprüfmusters die gleiche binäre Wertigkeit aufweist wie dasjenige Bit des Datenbitprüfmusters, dessen binäre Wertigkeit beim zweiten Schreibschritt (t2) im Vergleich zum ersten Schreibschritt (t1) komplementiert wurde.

**Claims**

**1.** Method for checking the contact connections of a writable and readable integrated electronic circuit, in particular of a memory module, to an address bus and a data bus, wherein

A. in at least one first sequence of write steps (t0 ... t4), selected address bit test patterns (.,0011,.) are written step-by-step to the address bus (A0,A1,.), and selected data bit test patterns (.,1100,.) on the data bus (D0,D1,.) are written to the circuit,

B. in at least one first sequence of read steps (t5 ... t9), the selected address bit test patterns (.,0011,.) are in turn written step-by-step to the address bus (A0,A1,.), and the associated data bit patterns (.,1100,.) on the data bus (D0,D1,.) are read from the circuit,

C. in at least one first sequence of test steps, the read data bit patterns are compared with the selected data test bit patterns and, in the event of discrepancies, the faulty line on the address bus (A0,A1,.) or data bus (D0,D1,.) is localized, in particular by pattern comparison with address and data bit fault patterns,

**characterized in that**

D. address and data bit test patterns are selected such that,

i) in a first step in the first sequence of write and read steps (t0 and t5 respectively), the bits in the address bit test pattern have a first, matching binary value (0000 and 1111 respectively), and,

ii) in the first step of the first sequence of write steps (t0), the bits in the data bit test pattern have a second, matching binary value (0000 and 1111, respectively), and

iii) for each following step in the respective sequence of write and read steps (t1,t2,t3 and t6,t7,t8, respectively), starting with the lowest-value or highest-value bit in the address or data bit test pattern, the respective adjacent bit is assigned the respective complementary binary value to the preceding step (.,0011,. or .,1100,., respectively), until,

iv) in a final step in the sequence of write or read steps (t4;t9), respectively, all the bits in the address and data bit test patterns, respectively, have a binary value (1111 or 0000, respectively) which is complementary to the respective first step.

2. Method according to Claim 1, wherein, in order to check the bits on the address bus (A5,A4) and on the data bus (D5,D4) which have a value which is greater than the value of the respective highest-value bit on the data bus (D3) or on the address bus (A3),

A. at least one second sequence (t12 ... t17) of write, read and test steps is carried out and, in the process

B. selected address and data bit test patterns are written

i) to those bits on the address or data bus (A5,A4; D5,D4), respectively, which have the greater value, and
ii) to those adjacent bits on the data or address bus (D1,D0;), respectively, which

a) have already had address or data bit test patterns, respectively, written to them in the first sequence of write, read and test steps (t0 ... t9), and

b) whose number, starting with the respective lowest-value or highest-value bit in this group, corresponds to the number of bits with the greater value.

3. Method according to Claim 1 or 2, wherein

A) following the first sequence of write, read and test steps (t0 ... t9), a respective additional write and read and test step (t10,t11) is carried out for the same address and data bus bits (A0, A1, ... ; D0,D1, ...), and, in the process, at least

B) the data bit test pattern is selected such that, in the additional write step (t10), at least the bit (D0) in the data bit test pattern has the same binary value as that bit in the data bit test pattern whose binary value in the second write step (t2) was complementary to that in the first write step (t1).

**Revendications**

1. Procédé de vérification des bornes de contact d'un circuit électronique intégré, dans lequel on peut écrire et lire, notamment d'un module de mémoire, à un bus d'adresses et à un bus de données, dans lequel

A. en au moins une première séquence d'étapes d'écriture (t0 à t4), on applique pas à pas sur le bus d'adresses (A0, A1, ...) des configurations binaires de test d'adresses sélectionnées (..., 0011, ...) et on écrit des configurations binaires de test de données sélectionnées (..., 1100, ...) sur le bus de données (D0, D1, ...) dans le circuit,
B. en au moins une première séquence d'étapes de lecture (t5 à t9), on applique à nouveau pas à pas sur le bus d'adresses (A0, A1, ...) des configurations binaires de test d'adresses sélectionnées (..., 0011, ...) et on lit les configurations binaires de données associées (..., 1100, ...) sur le bus de données (D0, D1, ...) dans le circuit,

C. en au moins une première séquence d'étapes de test, on compare les configurations binaires de données lues aux configurations binaires de test de données sélectionnées et, en cas d'écarts, on localise la ligne défectueuse sur le bus d'adresses (A0, A1, ...) ou sur le bus de données (D0, D1, ...), notamment par une comparaison de configuration avec des configurations binaires d'erreur d'adresses et avec des configurations binaires d'erreur de données,

**caractérisé par le fait que**

D. on sélectionne des configurations binaires de test d'adresses et de données de telle sorte que

i) dans une première étape de la première séquence d'étapes d'écriture ou de lecture (t0 ou t5), les bits de la configuration binaire de test d'adresses ont une première valeur binaire qui coïncide (0000 ou 1111), et

ii) dans la première étape de la première séquence d'étapes d'écriture (t0), les bits de la configuration binaire de test de données ont une deuxième valeur binaire qui coïncide (0000 ou 1111), et

iii) à chaque étape suivante de la séquence respective d'étapes d'écriture ou de lecture (t1, t2, t3 ou t6, t7, t8), en commençant par le bit de poids minimal ou par le bit de poids maximal dans la configuration binaire de test d'adresses ou de données, on associe au bit respectivement voisin la valeur binaire respectivement complémentaire (..., 0111, ... ou ..., 1000, ...) en comparaison avec l'étape précédente (..., 0011, ... ou ..., 1100, ...), jusqu'à ce que

iv) dans une dernière étape de la séquence d'étapes d'écriture ou de lecture (t4 ; t9), tous les bits de la configuration binaire de test d'adresses ou de données aient une valeur binaire (1111 ou 0000) complémentaire de celle à la première étape respective.

2. Procédé selon la revendication 1, dans lequel, pour vérifier des bits du bus d'adresses (A5, A4) ou du bus de données (D5, D4) qui ont une valeur supérieure à la valeur du bit respectivement de poids maximal du bus de données (D3) ou du bus d'adresses (A3),

A. on exécute au moins une deuxième séquence (t12 à t17) d'étapes d'écriture, de lecture et de test, et ce faisant

B. on applique des configurations binaires de test d'adresses et de données sélectionnées

i) aux bits du bus d'adresses ou de données (A5, A4 ; D5, D4) qui ont la valeur supérieure, et

ii) aux bits voisins du bus de données ou d'adresses (D1, D0)

a) qui ont déjà reçu des configurations binaires de test d'adresses ou de données dans la première séquence d'étapes d'écriture, de lecture et de test (t0 à t9), et

b) dont le nombre, en commençant par le bit respectivement de poids minimal ou de poids maximal de ce groupe, correspond au nombre des bits ayant la valeur supérieure.

3. Procédé selon la revendication 1 ou 2, dans lequel

A. suite à la première séquence d'étapes d'écriture, de lecture et de test (t0 à t9), on effectue pour les mêmes bits de bus d'adresses et de données (A0, A1, ... ; D0, D1, ...) à chaque fois une étape d'écriture, de lecture et de test supplémentaire (t10, t11), et ce faisant

B. on sélectionne au moins la configuration binaire de test de données de telle sorte que, dans l'étape d'écriture supplémentaire (t10), au moins le bit (D0) de la configuration binaire de test de données a la même valeur binaire que le bit de la configuration binaire de test de données dont la valeur binaire lors de la deuxième étape d'écriture (t2) était complémentaire en comparaison avec la première étape d'écriture (t1).

|  | Adressbus | | | | Datenbus | | | |
|---|---|---|---|---|---|---|---|---|
|  | A3 | A2 | A1 | A0 | D3 | D2 | D1 | D0 |
| Schritt : t0 (schreiben) | 0 | 0 | 0 | 0 | 0 | 0 | 0 | 0 |
| Schritt : t1 (schreiben) | 0 | 0 | 0 | 1 | 0 | 0 | 0 | 1 |
| Schritt : t2 (schreiben) | 0 | 0 | 1 | 1 | 0 | 0 | 1 | 1 |
| Schritt : t3 (schreiben) | 0 | 1 | 1 | 1 | 0 | 1 | 1 | 1 |
| Schritt : t4 (schreiben) | 1 | 1 | 1 | 1 | 1 | 1 | 1 | 1 |
| Schritt : t5 (lesen) | 0 | 0 | 0 | 0 | 0 | 0 | 0 | 0 |
| Schritt : t6 (lesen) | 0 | 0 | 0 | 1 | 0 | 0 | 0 | 1 |
| Schritt : t7 (lesen) | 0 | 0 | 1 | 1 | 0 | 0 | 1 | 1 |
| Schritt : t8 (lesen) | 0 | 1 | 1 | 1 | 0 | 1 | 1 | 1 |
| Schritt : t9 (lesen) | 1 | 1 | 1 | 1 | 1 | 1 | 1 | 1 |
| Schritt : t10 (schreiben) | 0 | 0 | 0 | 1 | 1 | 1 | 1 | 0 |
| Schritt : t11 (lesen) | 0 | 0 | 0 | 1 | 1 | 1 | 1 | 0 |

**" Gutfall " Beispiel 1**

Fig. 1

## Adressbus

**Fig. 2**

| | A3 | A2 | A1 | A0 |
|---|---|---|---|---|
| Schritt t0 | 0 | 0 | 0 | 0 |
| Schritt t1 | 0 | 0 | 0 | 1 |
| Schritt t2 | 0 | 0 | 1 | 1 |
| Schritt t3 | 0 | 1 | 1 | 1 |
| Schritt t4 | 1 | 1 | 1 | 1 |

**Fig. 3**

| | A3 | A2 | A1 | A0 |
|---|---|---|---|---|
| Schritt t0 | 1 | 1 | 1 | 1 |
| Schritt t1 | 1 | 1 | 1 | 0 |
| Schritt t2 | 1 | 1 | 0 | 0 |
| Schritt t3 | 1 | 0 | 0 | 0 |
| Schritt t4 | 0 | 0 | 0 | 0 |

**Fig. 4**

| | A3 | A2 | A1 | A0 |
|---|---|---|---|---|
| Schritt t0 | 0 | 0 | 0 | 0 |
| Schritt t1 | 1 | 0 | 0 | 0 |
| Schritt t2 | 1 | 1 | 0 | 0 |
| Schritt t3 | 1 | 1 | 1 | 0 |
| Schritt t4 | 1 | 1 | 1 | 1 |

**Fig. 5**

| | A3 | A2 | A1 | A0 |
|---|---|---|---|---|
| Schritt t0 | 1 | 1 | 1 | 1 |
| Schritt t1 | 0 | 1 | 1 | 1 |
| Schritt t2 | 0 | 0 | 1 | 1 |
| Schritt t3 | 0 | 0 | 0 | 1 |
| Schritt t4 | 0 | 0 | 0 | 0 |

## Datenbus

**Fig. 6**

| | D3 | D2 | D1 | D0 |
|---|---|---|---|---|
| Schritt t0 | 0 | 0 | 0 | 0 |
| Schritt t1 | 0 | 0 | 0 | 1 |
| Schritt t2 | 0 | 0 | 1 | 1 |
| Schritt t3 | 0 | 1 | 1 | 1 |
| Schritt t4 | 1 | 1 | 1 | 1 |
| Schritt t10 | d | d | d | 0 |

**Fig. 7**

| | D3 | D2 | D1 | D0 |
|---|---|---|---|---|
| Schritt t0 | 1 | 1 | 1 | 1 |
| Schritt t1 | 1 | 1 | 1 | 0 |
| Schritt t2 | 1 | 1 | 0 | 0 |
| Schritt t3 | 1 | 0 | 0 | 0 |
| Schritt t4 | 0 | 0 | 0 | 0 |
| Schritt t10 | d | d | d | 1 |

**Fig. 8**

| | D3 | D2 | D1 | D0 |
|---|---|---|---|---|
| Schritt t0 | 0 | 0 | 0 | 0 |
| Schritt t1 | 1 | 0 | 0 | 0 |
| Schritt t2 | 1 | 1 | 0 | 0 |
| Schritt t3 | 1 | 1 | 1 | 0 |
| Schritt t4 | 1 | 1 | 1 | 1 |
| Schritt t10 | 0 | d | d | d |

**Fig. 9**

| | D3 | D2 | D1 | D0 |
|---|---|---|---|---|
| Schritt t0 | 1 | 1 | 1 | 1 |
| Schritt t1 | 0 | 1 | 1 | 1 |
| Schritt t2 | 0 | 0 | 1 | 1 |
| Schritt t3 | 0 | 0 | 0 | 1 |
| Schritt t4 | 1 | 0 | 0 | 0 |
| Schritt t10 | d | d | d | d |

EP 1 027 707 B1

|  | Adressbus | | | | Datenbus | | | |
|---|---|---|---|---|---|---|---|---|
|  | A3 | A2 | A1 | A0 | D3 | D2 | D1 | D0 |
| Schritt : t0 (schreiben) | 0 | 0 | 0 | 0 | 0 | 0 | 0 | 0 |
| Schritt : t1 (schreiben) | 0 | 0 | 0 | (0) | 0 | 0 | 0 | 1 |
| Schritt : t2 (schreiben) | 0 | 0 | 1 | (0) | 0 | 0 | 1 | 1 |
| Schritt : t3 (schreiben) | 0 | 1 | 1 | (0) | 0 | 1 | 1 | 1 |
| Schritt : t4 (schreiben) | 1 | 1 | 1 | (0) | 1 | 1 | 1 | 1 |
| Schritt : t5 (lesen) | 0 | 0 | 0 | 0 | 0 | 0 | 0 | (1) |
| Schritt : t6 (lesen) | 0 | 0 | 0 | (0) | 0 | 0 | 0 | 1 |
| Schritt : t7 (lesen) | 0 | 0 | 1 | (0) | 0 | 0 | 1 | 1 |
| Schritt : t8 (lesen) | 0 | 1 | 1 | (0) | 0 | 1 | 1 | 1 |
| Schritt : t9 (lesen) | 1 | 1 | 1 | (0) | 1 | 1 | 1 | 1 |
| Schritt : t10 (schreiben) | 0 | 0 | 0 | (0) | 1 | 1 | 1 | 0 |
| Schritt : t11 (lesen) | 0 | 0 | 0 | (0) | 1 | 1 | 1 | 0 |

"Fehlerfall" :
Adressleitung A0 auf " open 0 "

Fig. 10

| | Adressbus | | | | Datenbus | | | |
|---|---|---|---|---|---|---|---|---|
| | A3 | A2 | A1 | A0 | D3 | D2 | D1 | D0 |
| Schritt : t0 (schreiben) | 0 | 0 | 0 | 0 | 0 | 0 | 0 | **0** |
| Schritt : t1 (schreiben) | 0 | 0 | 0 | 1 | 0 | 0 | 0 | (0) |
| Schritt : t2 (schreiben) | 0 | 0 | 1 | 1 | 0 | 0 | 1 | (0) |
| Schritt : t3 (schreiben) | 0 | 1 | 1 | 1 | 0 | 1 | 1 | (0) |
| Schritt : t4 (schreiben) | 1 | 1 | 1 | 1 | 1 | 1 | 1 | (0) |
| Schritt : t5 (lesen) | 0 | 0 | 0 | 0 | $\underline{0}$ | $\underline{0}$ | $\underline{0}$ | $\underline{0}$ |
| Schritt : t6 (lesen) | 0 | 0 | 0 | 1 | $\underline{0}$ | $\underline{0}$ | $\underline{0}$ | ($\underline{0}$) |
| Schritt : t7 (lesen) | 0 | 0 | 1 | 1 | $\underline{0}$ | $\underline{0}$ | $\underline{1}$ | ($\underline{0}$) |
| Schritt : t8 (lesen) | 0 | 1 | 1 | 1 | $\underline{0}$ | $\underline{1}$ | $\underline{1}$ | ($\underline{0}$) |
| Schritt : t9 (lesen) | 1 | 1 | 1 | 1 | $\underline{1}$ | $\underline{1}$ | $\underline{1}$ | ($\underline{0}$) |
| Schritt : t10 (schreiben) | 0 | 0 | 0 | 1 | 1 | 1 | 1 | 0 |
| Schritt : t11 (lesen) | 0 | 0 | 0 | 1 | $\underline{1}$ | $\underline{1}$ | $\underline{1}$ | $\underline{0}$ |

"Fehlerfall" :
Datenleitung D0 auf " open 0 "

Fig. 11

|  | Adressbus | | | | Datenbus | | | |
|---|---|---|---|---|---|---|---|---|
|  | A3 | A2 | A1 | A0 | D3 | D2 | D1 | D0 |
| Schritt : t0 (schreiben) | 0 | 0 | 0 | (1) | 0 | 0 | 0 | 0 |
| Schritt : t1 (schreiben) | 0 | 0 | 0 | 1 | 0 | 0 | 0 | 1 |
| Schritt : t2 (schreiben) | 0 | 0 | 1 | 1 | 0 | 0 | 1 | 1 |
| Schritt : t3 (schreiben) | 0 | 1 | 1 | 1 | 0 | 1 | 1 | 1 |
| Schritt : t4 (schreiben) | 1 | 1 | 1 | 1 | 1 | 1 | 1 | 1 |
| Schritt : t5 (lesen) | 0 | 0 | 0 | (1) | 0 | 0 | 0 | (1) |
| Schritt : t6 (lesen) | 0 | 0 | 0 | 1 | 0 | 0 | 0 | 1 |
| Schritt : t7 (lesen) | 0 | 0 | 1 | 1 | 0 | 0 | 1 | 1 |
| Schritt : t8 (lesen) | 0 | 1 | 1 | 1 | 0 | 1 | 1 | 1 |
| Schritt : t9 (lesen) | 1 | 1 | 1 | 1 | 1 | 1 | 1 | 1 |
| Schritt : t10 (schreiben) | 0 | 0 | 0 | 1 | 1 | 1 | 1 | 0 |
| Schritt : t11 (lesen) | 0 | 0 | 0 | 1 | 1 | 1 | 1 | 0 |

**"Fehlerfall" :**
**Adressleitung A0 auf " open 1 "**

Fig. 12

|  | Adressbus | | | | Datenbus | | | |
|---|---|---|---|---|---|---|---|---|
|  | A3 | A2 | A1 | A0 | D3 | D2 | D1 | D0 |
| Schritt : t0 (schreiben) | 0 | 0 | 0 | 0 | 0 | 0 | 0 | (1) |
| Schritt : t1 (schreiben) | 0 | 0 | 0 | 1 | 0 | 0 | 0 | 1 |
| Schritt : t2 (schreiben) | 0 | 0 | 1 | 1 | 0 | 0 | 1 | 1 |
| Schritt : t3 (schreiben) | 0 | 1 | 1 | 1 | 0 | 1 | 1 | 1 |
| Schritt : t4 (schreiben) | 1 | 1 | 1 | 1 | 1 | 1 | 1 | 1 |
| Schritt : t5 (lesen) | 0 | 0 | 0 | 0 | 0 | 0 | 0 | (1) |
| Schritt : t6 (lesen) | 0 | 0 | 0 | 1 | 0 | 0 | 0 | 1 |
| Schritt : t7 (lesen) | 0 | 0 | 1 | 1 | 0 | 0 | 1 | 1 |
| Schritt : t8 (lesen) | 0 | 1 | 1 | 1 | 0 | 1 | 1 | 1 |
| Schritt : t9 (lesen) | 1 | 1 | 1 | 1 | 1 | 1 | 1 | 1 |
| Schritt : t10 (schreiben) | 0 | 0 | 0 | 1 | 1 | 1 | 1 | (1) |
| Schritt : t11 (lesen) | 0 | 0 | 0 | 1 | 1 | 1 | 1 | (1) |

**" Fehlerfall " :**
**Datenleitung D0 auf " open 1 "**

Fig. 13

|  | Datenbus | | | | Datenbus | | | | Datenbus | | | | Datenbus | | | |
|---|---|---|---|---|---|---|---|---|---|---|---|---|---|---|---|---|
|  | D3 | D2 | D1 | D0 | D3 | D2 | D1 | D0 | D3 | D2 | D1 | D0 | D3 | D2 | D1 | D0 |
| Schritt : t5 (lesen) | 0 | 0 | 0 | (1) | 0 | 0 | 0 | 0 | 0 | 0 | 0 | (1) | 0 | 0 | 0 | (1) |
| Schritt : t6 (lesen) | 0 | 0 | 0 | 1 | 0 | 0 | 0 | (0) | 0 | 0 | 0 | 1 | 0 | 0 | 0 | 1 |
| Schritt : t7 (lesen) | 0 | 0 | 1 | 1 | 0 | 0 | 1 | (0) | 0 | 0 | 1 | 1 | 0 | 0 | 1 | 1 |
| Schritt : t8 (lesen) | 0 | 1 | 1 | 1 | 0 | 1 | 1 | (0) | 0 | 1 | 1 | 1 | 0 | 1 | 1 | 1 |
| Schritt : t9 (lesen) | 1 | 1 | 1 | 1 | 1 | 1 | 1 | (0) | 1 | 1 | 1 | 1 | 1 | 1 | 1 | 1 |
|  |  |  |  |  |  |  |  |  |  |  |  |  |  |  |  |  |
| Schritt : t11 (lesen) | 1 | 1 | 1 | 0 | 1 | 1 | 1 | 0 | 1 | 1 | 1 | 0 | 1 | 1 | 1 | (1) |
|  | **Adressleitung A0 auf " open 0 "** | | | | **Datenleitung D0 auf " open 0 "** | | | | **Adressleitung A0 auf " open 1 "** | | | | **Datenleitung D0 auf " open 1 "** | | | |

Fig. 14

EP 1 027 707 B1

| | A5 | A4 | A3 | A2 | A1 | A0 | D3 | D2 | D1 | D0 |
|---|---|---|---|---|---|---|---|---|---|---|
| | **Adressbus** | | | | | | **Datenbus** | | | |
| Schritt : t0 (schreiben) | d | d | 0 | 0 | 0 | 0 | 0 | 0 | 0 | 0 |
| Schritt : t1 (schreiben) | d | d | 0 | 0 | 0 | 1 | 0 | 0 | 0 | 1 |
| Schritt : t2 (schreiben) | d | d | 0 | 0 | 1 | 1 | 0 | 0 | 1 | 1 |
| Schritt : t3 (schreiben) | d | d | 0 | 1 | 1 | 1 | 0 | 1 | 1 | 1 |
| Schritt : t4 (schreiben) | d | d | 1 | 1 | 1 | 1 | 1 | 1 | 1 | 1 |
| Schritt : t5 (lesen) | d | d | 0 | 0 | 0 | 0 | 0 | 0 | 0 | 0 |
| Schritt : t6 (lesen) | d | d | 0 | 0 | 0 | 1 | 0 | 0 | 0 | 1 |
| Schritt : t7 (lesen) | d | d | 0 | 0 | 1 | 1 | 0 | 0 | 1 | 1 |
| Schritt : t8 (lesen) | d | d | 0 | 1 | 1 | 1 | 0 | 1 | 1 | 1 |
| Schritt : t9 (lesen) | d | d | 1 | 1 | 1 | 1 | 1 | 1 | 1 | 1 |
| Schritt : t10 (schreiben) | d | d | 0 | 0 | 0 | 1 | 1 | 1 | 1 | 0 |
| Schritt : t11 (lesen) | d | d | 0 | 0 | 0 | 1 | 1 | 1 | 1 | 0 |
| Schritt : t12 (schreiben) | 0 | 0 | d | d | d | d | d | d | 0 | 0 |
| Schritt : t13 (schreiben) | 0 | 1 | d | d | d | d | d | d | 0 | 1 |
| Schritt : t14 (schreiben) | 1 | 1 | d | d | d | d | d | d | 1 | 1 |
| Schritt : t15 (lesen) | 0 | 0 | d | d | d | d | d | d | 0 | 0 |
| Schritt : t16 (lesen) | 0 | 1 | d | d | d | d | d | d | 0 | 1 |
| Schritt : t17 (lesen) | 1 | 1 | d | d | d | d | d | d | 1 | 1 |

**Fig. 15**    " Gutfall" Beispiel 2

| | D5 | D4 | D3 | D2 | D1 | D0 | A3 | A2 | A1 | A0 |
|---|---|---|---|---|---|---|---|---|---|---|
| | **Datenbus** | | | | | | **Adressbus** | | | |
| Schritt : t0 (schreiben) | d | d | 0 | 0 | 0 | 0 | 0 | 0 | 0 | 0 |
| Schritt : t1 (schreiben) | d | d | 0 | 0 | 0 | 1 | 0 | 0 | 0 | 1 |
| Schritt : t2 (schreiben) | d | d | 0 | 0 | 1 | 1 | 0 | 0 | 1 | 1 |

**Fig. 16**    " Gutfall" Beispiel 3

| | | | Adressbus | | | | | | | Datenbus | | | |
|---|---|---|---|---|---|---|---|---|---|---|---|---|---|
| | A8 | A7 | A6 | A5 | A4 | A3 | A2 | A1 | A0 | D3 | D2 | D1 | D0 |
| Schritt : t0 (schreiben) | d | d | d | d | d | 0 | 0 | 0 | 0 | 0 | 0 | 0 | 0 |
| Schritt : t1 (schreiben) | d | d | d | d | d | 0 | 0 | 0 | 1 | 0 | 0 | 0 | 1 |
| Schritt : t2 (schreiben) | d | d | d | d | d | 0 | 0 | 1 | 1 | 0 | 0 | 1 | 1 |
| Schritt : t3 (schreiben) | d | d | d | d | d | 0 | 1 | 1 | 1 | 0 | 1 | 1 | 1 |
| Schritt : t4 (schreiben) | d | d | d | d | d | 1 | 1 | 1 | 1 | 1 | 1 | 1 | 1 |
| Schritt : t5 (lesen) | d | d | d | d | d | 0 | 0 | 0 | 0 | 0 | 0 | 0 | 0 |
| Schritt : t6 (lesen) | d | d | d | d | d | 0 | 0 | 0 | 1 | 0 | 0 | 0 | 1 |
| Schritt : t7 (lesen | d | d | d | d | d | 0 | 0 | 1 | 1 | 0 | 0 | 1 | 1 |
| Schritt : t8 (lesen) | d | d | d | d | d | 0 | 1 | 1 | 1 | 0 | 1 | 1 | 1 |
| Schritt : t9 (lesen) | d | d | d | d | d | 1 | 1 | 1 | 1 | 1 | 1 | 1 | 1 |
| Schritt : t10 (schreiben) | d | d | d | d | d | 0 | 0 | 0 | 1 | 1 | 1 | 1 | 0 |
| Schritt : t11 (lesen) | d | d | d | d | d | 0 | 0 | 0 | 1 | 1 | 1 | 1 | 0 |
| Schritt : t12 (schreiben) | d | 0 | 0 | 0 | 0 | d | d | d | d | 0 | 0 | 0 | 0 |
| Schritt : t13 (schreiben) | d | 0 | 0 | 0 | 1 | d | d | d | d | 0 | 0 | 0 | 1 |
| Schritt : t14 (schreiben) | d | 0 | 0 | 1 | 1 | d | d | d | d | 0 | 0 | 1 | 1 |
| Schritt : t15 (schreiben) | d | 0 | 1 | 1 | 1 | d | d | d | d | 0 | 1 | 1 | 1 |
| Schritt : t16 (schreiben) | d | 1 | 1 | 1 | 1 | d | d | d | d | 1 | 1 | 1 | 1 |
| Schritt : t17 (lesen) | d | 0 | 0 | 0 | 0 | d | d | d | d | 0 | 0 | 0 | 0 |
| Schritt : t18 (lesen) | d | 0 | 0 | 0 | 1 | d | d | d | d | 0 | 0 | 0 | 1 |
| Schritt : t19 (lesen | d | 0 | 0 | 1 | 1 | d | d | d | d | 0 | 0 | 1 | 1 |
| Schritt : t20 (lesen) | d | 0 | 1 | 1 | 1 | d | d | d | d | 0 | 1 | 1 | 1 |
| Schritt : t21 (lesen) | d | 1 | 1 | 1 | 1 | d | d | d | d | 1 | 1 | 1 | 1 |
| Schritt : t22 (schreiben) | 0 | d | d | d | d | d | d | d | d | d | d | d | 0 |
| Schritt : t23 (schreiben) | 1 | d | d | d | d | d | d | d | d | d | d | d | 1 |
| Schritt : t24 (lesen) | 0 | d | d | d | d | d | d | d | d | d | d | d | 0 |
| Schritt : t25 (lesen) | 1 | d | d | d | d | d | d | d | d | d | d | d | 1 |

" Gutfall " Beispiel 4

Fig. 17

|  | Adressbus | | | | | | Datenbus | | | |
|---|---|---|---|---|---|---|---|---|---|---|
|  | A5 | A4 | A3 | A2 | A1 | A0 | D3 | D2 | D1 | D0 |
| Schritt : t12 (schreiben) | 0 | **0** | d | d | d | d | d | d | 0 | 0 |
| Schritt : t13 (schreiben) | 0 | **0** | d | d | d | d | d | d | 0 | 1 |
| Schritt : t14 (schreiben) | 1 | **0** | d | d | d | d | d | d | 1 | 1 |
| Schritt : t15 (lesen) | 0 | 0 | d | d | d | d | d̲ | d̲ | 0̲ | 1̲ |
| Schritt : t16 (lesen) | 0 | **0** | d | d | d | d | d̲ | d̲ | 0̲ | 1̲ |
| Schritt : t17 (lesen) | 1 | **0** | d | d | d | d | d̲ | d̲ | 1̲ | 1̲ |

**"Fehlerfall" :**
**Adreßleitung A4 auf " open 0 "**

## Fig. 18

|  | Adressbus | | | | | | Datenbus | | | |
|---|---|---|---|---|---|---|---|---|---|---|
|  | A5 | A4 | A3 | A2 | A1 | A0 | D3 | D2 | D1 | D0 |
| Schritt : t12 (schreiben) | 0 | 1 | d | d | d | d | d | d | 0 | 0 |
| Schritt : t13 (schreiben) | 0 | 1 | d | d | d | d | d | d | 0 | 1 |
| Schritt : t14 (schreiben) | 1 | 1 | d | d | d | d | d | d | 1 | 1 |
| Schritt : t15 (lesen) | 0 | 1 | d | d | d | d | d̲ | d̲ | 0̲ | 1̲ |
| Schritt : t16 (lesen) | 0 | 1 | d | d | d | d | d̲ | d̲ | 0̲ | 1̲ |
| Schritt : t17 (lesen) | 1 | 1 | d | d | d | d | d̲ | d̲ | 1̲ | 1̲ |

**"Fehlerfall" :**
**Adreßleitung A4 auf "open1"**

## Fig. 19

|  | Adressbus | | | | | | Datenbus | | | |
|  | A5 | A4 | A3 | A2 | A1 | A0 | D3 | D2 | D1 | D0 |
|---|---|---|---|---|---|---|---|---|---|---|
| Schritt : t12 (schreiben) | **0** | 0 | d | d | d | d | d | d | 0 | 0 |
| Schritt : t13 (schreiben) | **0** | 1 | d | d | d | d | d | d | 0 | 1 |
| Schritt : t14 (schreiben) | (0) | 1 | d | d | d | d | d | d | 1 | 1 |
| Schritt : t15 (lesen) | **0** | 0 | d | d | d | d | $\underline{d}$ | $\underline{d}$ | $\underline{0}$ | $\underline{0}$ |
| Schritt : t16 (lesen) | **0** | 1 | d | d | d | d | $\underline{d}$ | $\underline{d}$ | (1) | $\underline{1}$ |
| Schritt : t17 (lesen) | (0) | 1 | d | d | d | d | $\underline{d}$ | $\underline{d}$ | $\underline{1}$ | $\underline{1}$ |

**"Fehlerfall" :**
**Adreßleitung A5 auf "open0"**

## Fig. 20

|  | Adressbus | | | | | | Datenbus | | | |
|  | A5 | A4 | A3 | A2 | A1 | A0 | D3 | D2 | D1 | D0 |
|---|---|---|---|---|---|---|---|---|---|---|
| Schritt : t12 (schreiben) | (1) | 0 | d | d | d | d | d | d | 0 | 0 |
| Schritt : t13 (schreiben) | (1) | 1 | d | d | d | d | d | d | 0 | 1 |
| Schritt : t14 (schreiben) | **1** | 1 | d | d | d | d | d | d | 1 | 1 |
| Schritt : t15 (lesen) | (1) | 0 | d | d | d | d | $\underline{d}$ | $\underline{d}$ | $\underline{0}$ | $\underline{0}$ |
| Schritt : t16 (lesen) | (1) | 1 | d | d | d | d | $\underline{d}$ | $\underline{d}$ | (1) | $\underline{1}$ |
| Schritt : t17 (lesen) | **1** | 1 | d | d | d | d | $\underline{d}$ | $\underline{d}$ | $\underline{1}$ | $\underline{1}$ |

**"Fehlerfall" :**
**Adreßleitung A5 auf "open1"**

## Fig. 21